# EUROPEAN PATENT APPLICATION

(11) **EP 4 447 136 A1**
(43) Date of publication of application: **16.10.2024**
(21) Application number: 22922255.9
(22) Date of filing: 19.01.2022
(51) Int. Cl.: H01L 33/62, H01L 33/38, H01L 27/15

(54) **DISPLAY DEVICE**

(71) Applicant: LG Electronics Inc., Yeongdeungpo-gu Seoul 07336 (KR)
(72) Inventor: CHOI, Jinhyeok, Seoul 06772 (KR); CHUNG, Indo, Seoul 06772 (KR); KIM, Youngdo, Seoul 06772 (KR)
(74) Representative: Vossius & Partner Patentanwälte Rechtsanwälte mbB
(86) International application number: PCT/KR2022/000946
(87) International publication number: WO 2023/140393

(57) **Abstract**

A display device can include a substrate, a first assembling wiring on the substrate, a second assembling wiring on the substrate, a partition wall disposed on the first and second assembling wirings and having a hole, a semiconductor light-emitting device disposed in the hole and having a first step difference part on a side portion thereof, and a connection electrode disposed on at least the first step difference part.

## Description

### BACKGROUND OF THE DISCLOSURE

### Field

The embodiment relates to a display device.

### Discussion of the Related Art

Large-area displays include liquid crystal displays (LCDs), OLED displays, and micro-LED displays.

A micro-LED display is a display that uses micro-LEDs, which are semiconductor light-emitting devices with a diameter or cross-sectional area of 100*µ*m or less, as display elements.

Since a micro-LED display uses micro-LEDs, which are semiconductor light-emitting devices, as display elements, it has excellent performance in many characteristics such as contrast ratio, response speed, color reproducibility, viewing angle, brightness, resolution, lifespan, luminous efficiency, and luminance.

In particular, a micro-LED display has the advantage of being able to freely adjust the size or resolution and implement a flexible display because the screen can be separated and combined in a modular manner.

However, since a large-area micro-LED display requires millions or more micro-LEDs, there is a technical problem that it is difficult to quickly and accurately transfer micro-LEDs to a display panel.

Recently developed transfer technologies include the pick and place process, the laser lift-off method, the self-assembly method, etc.

Among these, the self-assembly method is a method in which semiconductor light-emitting devices find their own assembly positions within a fluid, and is advantageous for implementing large-screen display devices.

However, research on the technology for manufacturing displays through self-assembly of micro-LEDs is still insufficient.

In particular, in the conventional technology, when transferring millions or more semiconductor light-emitting devices to a large display quickly, the transfer speed can be improved, but the transfer error rate can increase, which causes a technical problem in that the transfer yield is low.

In related technologies, a self-assembly transfer process using dielectrophoresis (DEP) is being attempted, but there is a problem in that the self-assembly rate is low due to the unevenness of the DEP force.

On the other hand, according to the undisclosed internal technology, DEP force is required for self-assembly, but due to the difficulty in uniformly controlling the DEP force, there is a problem that the semiconductor light-emitting device is not in the normal position within the assembly hole when assembling using self-assembly.

In addition, due to the phenomenon of the semiconductor light-emitting device being slanted, there is a problem that the electrical contact characteristics are deteriorated in the subsequent electrical contact process, resulting in a lower lighting rate.

Therefore, according to the undisclosed internal technology, DEP force is required for self-assembly, but when using DEP force, there is a technical contradiction in that the electrical contact characteristics are deteriorated due to the phenomenon of the semiconductor light-emitting device being slanted.

On the other hand, according to the undisclosed internal technology, after self-assembly, the lower contact bonding is performed using a solder metal such as Sn or In provided on the lower side of the semiconductor light-emitting device. However, due to the low melting point of the solder metal, it is not well deposited on the lower side of the semiconductor light-emitting device, and even if it is deposited, it has uneven roughness. Due to poor deposition or uneven roughness of solder metal, poor contact between the lower side of the semiconductor light-emitting device and the electrode wiring occurs, resulting in a problem of brightness deviation between multiple pixels or multiple sub-pixels or a decrease in the lighting rate. In addition, due to uneven roughness of the solder metal, there is a problem of tilt failure in which the semiconductor light-emitting device is bonded to the electrode wiring in a tilted state.

### SUMMARY OF THE DISCLOSURE

An object of the embodiment is to solve the foregoing and other problems.

Another object of the embodiment is to provide a display device having a new structure that does not require solder metal.

Another object of the embodiment is to provide a display device capable of preventing poor contact and improving the lighting rate.

Another object of the embodiment is to provide a display device capable of improving electrical and optical characteristics.

The technical problems of the embodiments are not limited to those described in this item and include those that can be understood through the description of the invention.

According to one aspect of the embodiment to achieve the above or other purposes, a display device, comprising: a substrate; a first assembling wiring on the substrate; a second assembling wiring on the substrate; a partition wall disposed on the first and second assembling wirings and having a hole; a semiconductor light-emitting device disposed in the hole and having a first step difference part on a side portion thereof; and a connection electrode disposed on at least the first step difference part.

The semiconductor light-emitting device may comprise a first conductivity type semiconductor layer; an active layer on the first conductivity type semiconductor layer; and a second conductivity type semiconductor layer on the active layer; and a passivation layer surrounding at least the active layer and the second conductivity type semiconductor layer, and the first step difference part may be disposed on a side portion of the first conductivity type semiconductor layer.

The first conductivity type semiconductor layer may comprise a first-first conductivity type semiconductor layer having a first width; and a first-second conductivity type semiconductor layer disposed on the first-first conductivity type semiconductor layer and having a second width smaller than the first width.

The first step difference part may comprise a first-first side region on a side portion of the first-first conductivity type semiconductor layer; a first-second side region on a side portion of the first-second conductivity type semiconductor layer; and a first bottom region on an upper side of the first-first conductivity type semiconductor layer between the first-first side region and the first-second side region.

The connection electrode may be in contact with the first-first side region and the first bottom region.

The semiconductor light-emitting device may comprise a first electrode below the first conductivity type semiconductor layer; and a second electrode on the second conductivity type semiconductor layer.

The connection electrode may be in contact with a side portion of the first electrode.

The connection electrode may be disposed on a passivation layer of the semiconductor light-emitting device.

The first electrode may be disposed on the first step difference part, and the connection electrode may be in contact with the first electrode.

The partition wall may have a second step difference part on the side portion thereof.

The partition wall may comprise a first partition wall spaced apart from the semiconductor light-emitting device by a first distance; and a second partition wall spaced apart from the semiconductor light-emitting device by a second distance and disposed on the first partition wall, the second distance being greater than the first distance.

The second step difference part may comprise a second-first side region on a side portion of the first partition wall; a second-second side region on a side portion of the second partition wall; and a second bottom region on an upper side of the second partition wall between the first partition wall and the second partition wall.

The connection electrode may be disposed on the second-first side region and the second bottom region.

The first assembling wiring and the second assembling wiring may be disposed on different layers, and the connection electrode may be electrically connected to at least one of the first assembling wiring or the second assembling wiring.

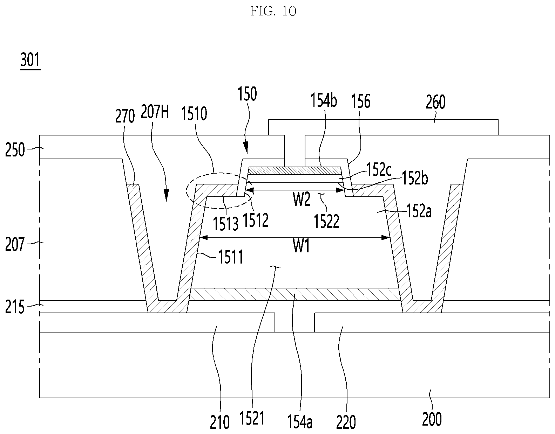

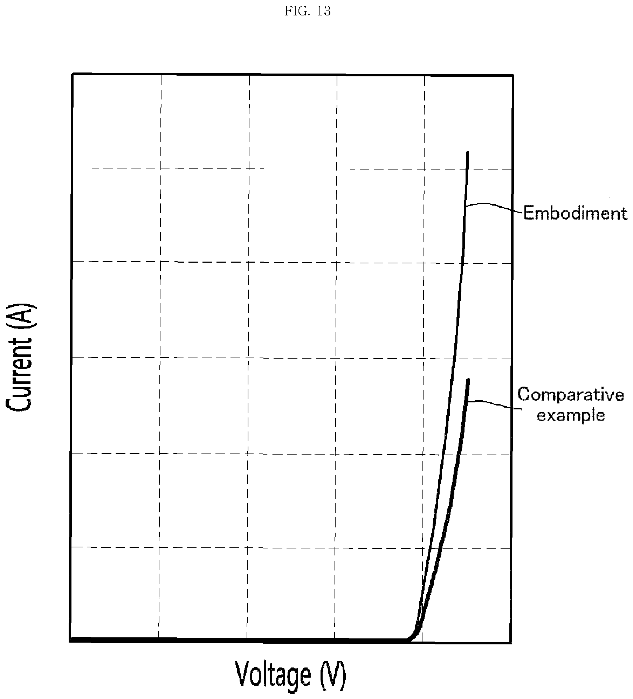

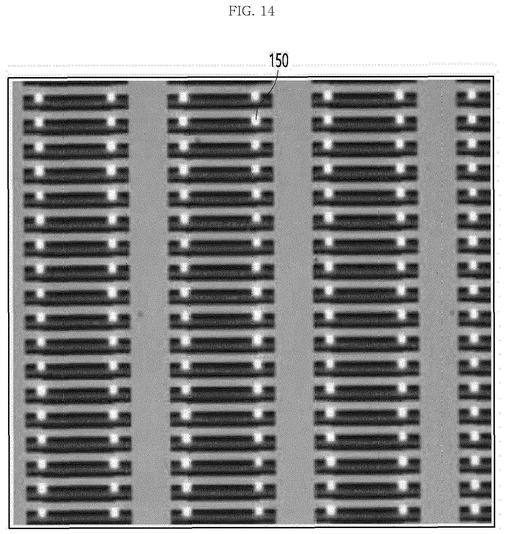

As shown in FIG. 10, since a step difference part 1510 is formed on the side portion of the semiconductor light-emitting device 150, and a connection electrode 270 is disposed on the step difference part 1510, the electrical contact area between the connection electrode 270 and the semiconductor light-emitting device 150 can be expanded, so that a larger current can flow in the semiconductor light-emitting device 150 (FIG. 13). Since a larger current flows in the semiconductor light-emitting device 150, the luminance of the semiconductor light-emitting device 150 can be increased and a smaller voltage can be applied, so that low-voltage operation is possible and power consumption can be reduced. In addition, since poor contact between the semiconductor light-emitting device 150 and the connection electrode 270 does not occur, lighting is possible in all pixels and all sub-pixels, as shown in FIG. 14, so that poor lighting rate can be prevented and yield can be improved.

In addition, since the connection electrode 270 is in contact with not only the upper surface of the first assembling wiring 210 and/or the second assembling wiring 220, but also the inner side surface of the insulating layer 215, the side portion of the first electrode 154a, the first-first side region 1511 of the step difference part 1510, and the bottom region 1513 of the step difference part 1510, the semiconductor light-emitting device 150 can be more firmly fixed, thereby improving product reliability.

In addition, since the connection electrode 270 is disposed on the side portion of the first conductivity type semiconductor layer 152a of the semiconductor light-emitting device 150 as well as the step difference part 1510, the light inside the semiconductor light-emitting device 150 may be reflected by the connection electrode 270, thereby improving the light efficiency of the semiconductor light-emitting device 150 and improving the light output or luminance.

In addition, since the thermal conductivity of the connection electrode 270 is high, the heat generated from the semiconductor light-emitting device 150 may be quickly released to the outside through the connection electrode 270, the first assembling wiring 210, and the second assembling wiring 220, so that the heat dissipation characteristics can be improved, the lifespan can be extended, and thermal fatigue can be improved.

In addition, since the electrical contact on the lower side of the semiconductor light-emitting device 150 is made through the side portion of the semiconductor light-emitting device 150 using the connection electrode 270, solder metal for the electrical contact on the lower side of the semiconductor light-emitting device 150 is not required, so not only can the material cost be reduced, but also various defects or failures due to the use of solder metal can be prevented.

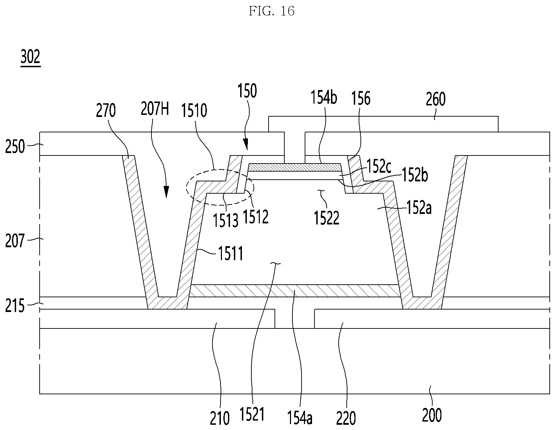

In addition, as illustrated in FIG. 16, the connection electrode 270 may be positioned not only on the side portion of the first electrode 154a but also on the step difference part 1510 and the passivation layer 156, so that a wider area of the semiconductor light-emitting device 150 can be covered by the connection electrode 270, thereby enhancing the fixation of the semiconductor light-emitting device 150.

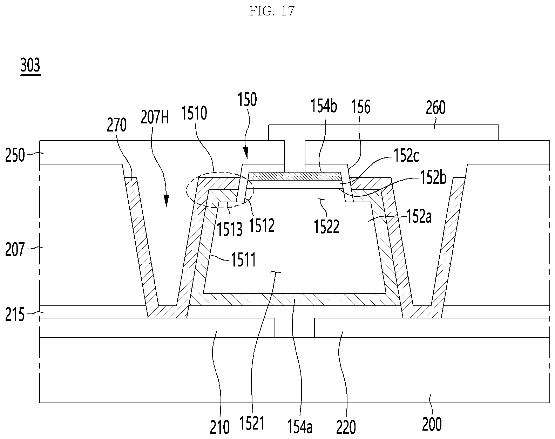

In addition, as illustrated in FIG. 17, the first electrode 154a may be disposed on the side portion as well as the lower side of the semiconductor light-emitting device 150. In particular, the first electrode 154a may be disposed on the step difference part 1510 on the side portion of the semiconductor light-emitting device 150. In this case, the connection electrode 270 may come into contact with the first electrode 154a disposed on the step difference part 1510 along with the side portion of the semiconductor light-emitting device 150 and come into contact with the entire area of the first electrode 154a disposed along the perimeter of the side portion of the semiconductor light-emitting device 150, so that the electrical contact area can be significantly expanded to reduce power consumption and improve the lighting rate.

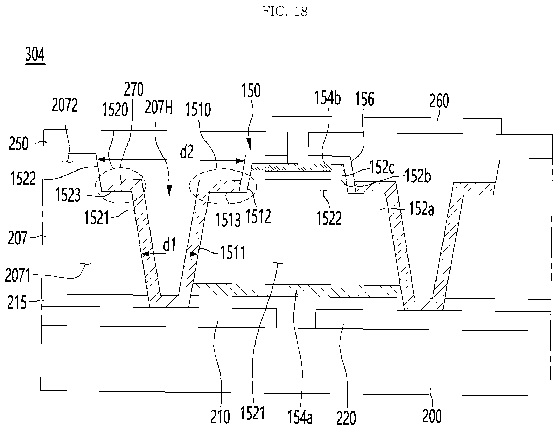

In addition, as illustrated in FIG. 18, a first step difference part 1510 may be disposed on the side portion of the semiconductor light-emitting device 150, a second step difference part 1530 may be disposed on the side portion of the partition wall 207, and a connection electrode 270 may be disposed on each of the first step difference part 1510 and the second step difference part 1530, thereby enhancing the fixation of the semiconductor light-emitting device 150 and improving product reliability.

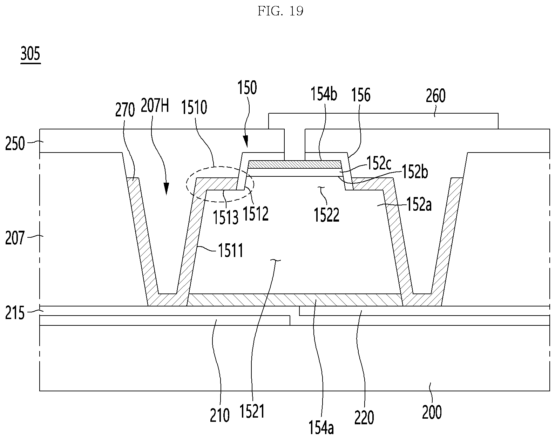

In addition, as illustrated in FIG. 19, since the first assembling wiring 210 and the second assembling wiring 220 are disposed on different layers and the second assembling wiring 220 is exposed by the assembly hole 207H, the lower side portion of the semiconductor light-emitting device 150 mounted on the assembly hole 207H can be electrically connected to the second assembling wiring 220. In addition, the connection electrode 270 can be electrically connected to the step difference part 1510 along with the side portion of the semiconductor light-emitting device 150. Accordingly, the contact area of the semiconductor light-emitting device 150 can be maximized, thereby dramatically reducing power consumption and improving the lighting rate.

Additional scope of applicability of the embodiments will become apparent from the detailed description that follows. However, since various changes and modifications within the spirit and scope of the embodiments may be clearly understood by those skilled in the art, the detailed description and specific embodiments, such as preferred embodiments, should be understood as being given by way of example only.

### BRIEF DESCRIPTION OF THE DRAWINGS

FIG. 1 illustrates a living room of a house in which a display device according to an embodiment is disposed.
FIG. 2 is a block diagram schematically showing a display device according to an embodiment.
FIG. 3 is a circuit diagram showing an example of a pixel of FIG. 2.
FIG. 4 is an enlarged view of a first panel area in the display device of FIG. 1.
FIG. 5 is an enlarged view of the A2 area of FIG. 4.
FIG. 6 is a drawing showing an example of assembling a light-emitting device according to an embodiment on a substrate by a self-assembly method.
FIG. 7 is a partial enlarged view of the A3 area of FIG. 6.
FIGS. 8A to 8B are examples of self-assembly in a display device according to an internal technology.
FIG. 8C is a self-assembly photograph of a display device according to an internal technology.
FIG. 8D is a drawing showing a tilt phenomenon that occurs during self-assembly of a display device according to an internal technology.
FIG. 8E is a focused ion beam (FIB) photograph of a light-emitting device (chip) and a bonding metal in a display panel according to an internal technology.
FIG. 9 is a plan view showing a display device according to a first embodiment.
FIG. 10 is a cross-sectional view taken along the C1-C2 line of FIG. 9.
FIG. 11 illustrates an assembly process of a semiconductor light-emitting device.
FIG. 12 illustrates a light-emitting process of a display device according to the first embodiment.
FIG. 13 illustrates electrical characteristics of a display device.
FIG. 14 shows a lighting image of a display device according to the first embodiment.
FIGS. 15A to 15F are drawings explaining a manufacturing method of a display device according to the first embodiment.
FIG. 16 is a plan view illustrating a display device according to a second embodiment.
FIG. 17 is a plan view illustrating a display device according to a third embodiment.
FIG. 18 is a plan view illustrating a display device according to a fourth embodiment.
FIG. 19 is a plan view illustrating a display device according to a fifth embodiment.

The sizes, shapes, dimensions, etc. of elements shown in the drawings can differ from actual ones. In addition, even if the same elements are shown in different sizes, shapes, dimensions, etc. between the drawings, this is only an example on the drawing, and the same elements have the same sizes, shapes, dimensions, etc. between the drawings.

### DETAILED DESCRIPTION OF EMBODIMENTS

Hereinafter, the embodiments disclosed in this specification will be described in detail with reference to the attached drawings, and the same or similar components will be assigned the same reference numbers regardless of the drawing symbols, and redundant descriptions thereof will be omitted. The suffixes 'module' and 'part' for components used in the following description are assigned or used interchangeably for the sake of ease of specification writing, and do not have distinct meanings or roles in themselves. In addition, the attached drawings are intended to facilitate easy understanding of the embodiments disclosed in this specification, and the technical ideas disclosed in this specification are not limited by the attached drawings. In addition, when an element such as a layer, region, or substrate is mentioned as existing 'on' another element, this includes that it may be directly on the other element, or that other intermediate elements may exist between them.

The display device described in the specification may comprise a TV, a signage, a mobile phone, a smart phone, a head-up display (HUD) for a vehicle, a backlight unit for a laptop computer, a display for VR or AR, etc. However, the configuration according to the embodiment described in the specification may be applied to a device capable of displaying, even if it is a new product type developed in the future.

The following describes a light-emitting device according to an embodiment and a display device comprising the same.

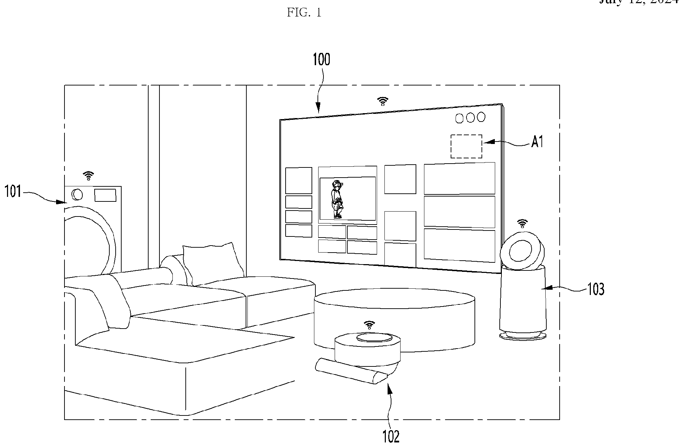

FIG. 1 illustrates a living room of a house in which a display device according to an embodiment is disposed.

Referring to FIG. 1, the display device 100 according to the embodiment can display the status of various electronic products such as a washing machine 101, a robot vacuum cleaner 102, and an air purifier 103, and can communicate with each electronic product based on IoT and control each electronic product based on user setting data.

The display device 100 according to the embodiment may comprise a flexible display manufactured on a thin and flexible substrate. The flexible display can be bent or rolled like paper while maintaining the characteristics of an existing flat display.

In a flexible display, visual information can be implemented by independently controlling the light emission of unit pixels disposed in a matrix form. A unit pixel means a minimum unit for implementing one color. The unit pixel of a flexible display can be implemented by a light-emitting device. In an embodiment, the light-emitting device may be a Micro-LED or a Nano-LED, but is not limited thereto.

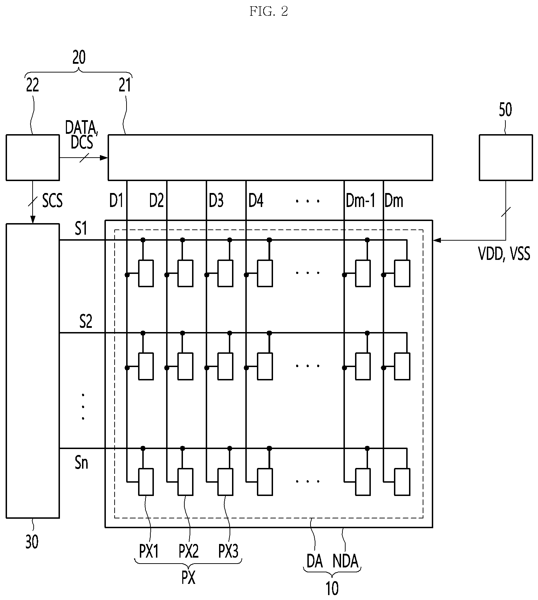

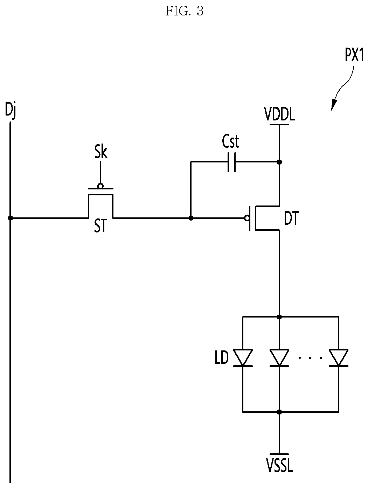

FIG. 2 is a block diagram schematically showing a display device according to an embodiment, and FIG. 3 is a circuit diagram showing an example of a pixel of FIG. 2.

Referring to FIGS. 2 and 3, the display device according to the embodiment may comprise a display panel 10, a driving circuit 20, a scan driving circuit 30, and a power supply circuit 50.

The display device 100 of the embodiment may drive the light-emitting device in an active matrix (AM) method or a passive matrix (PM) method.

The driving circuit 20 may comprise a data driving circuit 21 and a timing control circuit 22.

The display panel 10 may be formed in a rectangular shape, but is not limited thereto. That is, the display panel 10 may be formed in a circular or oval shape. At least one side of the display panel 10 may be formed to be bent at a predetermined curvature.

The display panel 10 may be divided into a display area DA and a non-display area NDA disposed around the display area DA. The display area DA is an area where pixels PX are formed to display an image. The display panel 10 may comprise data lines (D1 to Dm, m is an integer greater than or equal to 2), scan lines (S1 to Sn, n is an integer greater than or equal to 2) intersecting the data lines D1 to Dm, a high-potential voltage line VDDL to which a high-potential voltage is supplied, a low-potential voltage line VSSL to which a low-potential voltage is supplied, and pixels PX connected to the data lines D1 to Dm and the scan lines S1 to Sn.

Each of the pixels PX may comprise a first sub-pixel PX1, a second sub-pixel PX2, and a third sub-pixel PX3. The first sub-pixel PX1 may emit a first color light of a first main wavelength, the second sub-pixel PX2 may emit a second color light of a second main wavelength, and the third sub-pixel PX3 may emit a third color light of a third main wavelength. The first color light may be red light, the second color light may be green light, and the third color light may be blue light, but is not limited thereto. In addition, although FIG. 2 exemplifies that each of the pixels PX includes three sub-pixels, but is not limited thereto. That is, each of the pixels PX may comprise four or more sub-pixels.

Each of the first sub-pixel PX1, the second sub-pixel PX2, and the third sub-pixel PX3 may be connected to at least one of the data lines D1 to Dm, at least one of the scan lines S1 to Sn, and a high-potential voltage line VDDL. The first sub-pixel PX1 may comprise light-emitting devices LD as shown in FIG. 3, a plurality of transistors for supplying current to the light-emitting devices LD, and at least one capacitor Cst.

Although not shown in the drawing, each of the first sub-pixel PX1, the second sub-pixel PX2, and the third sub-pixel PX3 may comprise only one light-emitting device LD and at least one capacitor Cst.

Each of the light-emitting devices LD may be a semiconductor light-emitting diode comprising a first electrode, a plurality of conductivity type semiconductor layers, and a second electrode. Here, the first electrode may be an anode electrode, and the second electrode may be a cathode electrode, but is not limited thereto.

The light-emitting device LD may be one of a lateral type light-emitting device, a flip-chip light-emitting device, and a vertical type light-emitting device.

The plurality of transistors may comprise a driving transistor DT that supplies current to the light-emitting devices LD, and a scan transistor ST that supplies a data voltage to a gate electrode of the driving transistor DT, as shown in FIG. 3. The driving transistor DT may comprise a gate electrode connected to a source electrode of the scan transistor ST, a source electrode connected to a high-potential voltage line VDDL to which a high-potential voltage is applied, and a drain electrode connected to the first electrodes of the light-emitting devices LD. The scan transistor ST may comprise a gate electrode connected to a scan line (Sk, where k is an integer satisfying 1≤k≤n), a source electrode connected to a gate electrode of a driving transistor DT, and a drain electrode connected to a data line (Dj, where j is an integer satisfying 1≤j≤m).

A capacitor Cst is formed between the gate electrode and the source electrode of the driving transistor DT. The storage capacitor Cst charges a difference value between the gate voltage and the source voltage of the driving transistor DT.

The driving transistor DT and the scan transistor ST may be formed as thin film transistors. In addition, in FIG. 3, the driving transistor DT and the scan transistor ST were described mainly as being formed as P-type metal oxide semiconductor field effect transistors (MOSFETs), but is not limited thereto. The driving transistor DT and the scan transistor ST may also be formed as N-type MOSFETs. In this case, the positions of the source electrode and the drain electrode of each of the driving transistor DT and the scan transistor ST can be changed.

In addition, in FIG. 3, it is exemplified that each of the first sub-pixel PX1, the second sub-pixel PX2, and the third sub-pixel PX3 comprises 2T1C (2 Transistor - 1 capacitor) having one driving transistor DT, one scan transistor ST, and one capacitor Cst, but is not limited thereto. Each of the first sub-pixel PX1, the second sub-pixel PX2, and the third sub-pixel PX3 may comprise a plurality of scan transistors ST and a plurality of capacitors Cst.

Since the second sub-pixel PX2 and the third sub-pixel PX3 can be expressed in a circuit diagram substantially the same as that of the first sub-pixel PX1, a detailed description thereof will be omitted.

The driving circuit 20 outputs signals and voltages for driving the display panel 10. For this purpose, the driving circuit 20 may comprise a data driving circuit 21 and a timing control circuit 22.

The data driving circuit 21 receives digital video data DATA and a source control signal DCS from the timing control circuit 22. The data driving circuit 21 converts digital video data DATA into analog data voltages according to the source control signal DCS and supplies the converted data to the data lines D1 to Dm of the display panel 10.

The timing control circuit 22 receives digital video data DATA and timing signals from the host system. The timing signals may comprise a vertical sync signal, a horizontal sync signal, a data enable signal, and a dot clock. The host system may be an application processor of a smartphone or tablet PC, a monitor, a system on chip of a TV, etc.

The timing control circuit 22 generates control signals for controlling the operation timing of the data driving circuit 21 and the scan driving circuit 30. The control signals may comprise a source control signal DCS for controlling the operation timing of the data driving circuit 21 and a scan control signal SCS for controlling the operation timing of the scan driving circuit 30.

The driving circuit 20 may be disposed in a non-display area NDA provided on one side of the display panel 10. The driving circuit 20 may be formed as an integrated circuit (IC) and mounted on the display panel 10 using a chip on glass (COG) method, a chip on plastic (COP) method, or an ultrasonic bonding method, but is not limited thereto. For example, the driving circuit 20 may be mounted on a circuit board (not shown) instead of the display panel 10.

The data driving circuit 21 may be mounted on the display panel 10 using a COG method, a COP method, or an ultrasonic bonding method, and the timing control circuit 22 may be mounted on a circuit board.

The scan driving circuit 30 receives a scan control signal SCS from the timing control circuit 22. The scan driving circuit 30 generates scan signals according to the scan control signal SCS and supplies them to the scan lines S1 to Sn of the display panel 10. The scan driving circuit 30 may comprise a plurality of transistors and may be formed in a non-display area NDA of the display panel 10. Alternatively, the scan driving circuit 30 may be formed as an integrated circuit, in which case it may be mounted on a gate flexible film attached to the other side of the display panel 10.

The circuit board may be attached to pads provided on one edge of the display panel 10 using an anisotropic conductive film. As a result, the lead lines of the circuit board may be electrically connected to the pads. The circuit board may be a flexible film such as a flexible printed circuit board, a printed circuit board, or a chip on film. The circuit board may be bent to the bottom of the display panel 10. As a result, one side of the circuit board may be attached to one edge of the display panel 10, and the other side may be connected to a system board on which a host system is mounted, and may be disposed on the bottom of the display panel 10.

The power supply circuit 50 may generate voltages required for driving the display panel 10 from the main power applied from the system board and supply the voltages to the display panel 10. For example, the power supply circuit 50 can generate a high-potential voltage VDD and a low-potential voltage VSS for driving the light-emitting devices LD of the display panel 10 from the main power supply and supply them to the high-potential voltage line VDDL and the low-potential voltage line VSSL of the display panel 10. In addition, the power supply circuit 50 can generate and supply driving voltages for driving the driving circuit 20 and the scan driving circuit 30 from the main power supply.

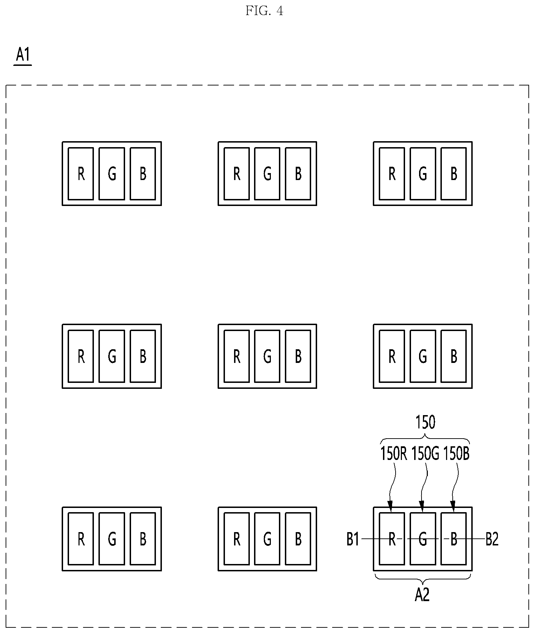

FIG. 4 is an enlarged view of the first panel area in the display device of FIG. 3.

Referring to FIG. 4, the display device 100 of the embodiment can be manufactured by mechanically and electrically connecting a plurality of panel areas such as the first panel area A1 by tiling.

The first panel area A1 can comprise a plurality of semiconductor light-emitting devices 150 disposed for each unit pixel (PX of FIG. 2).

For example, a unit pixel PX may comprise a first sub-pixel PX1, a second sub-pixel PX2, and a third sub-pixel PX3. For example, a plurality of red semiconductor light-emitting devices 150R may be disposed in a first sub-pixel PX1, a plurality of green semiconductor light-emitting devices 150G may be disposed in a second sub-pixel PX2, and a plurality of blue semiconductor light-emitting devices 150B may be disposed in a third sub-pixel PX3. The unit pixel PX may further comprise a fourth sub-pixel in which no semiconductor light-emitting devices are disposed, but is not limited thereto.

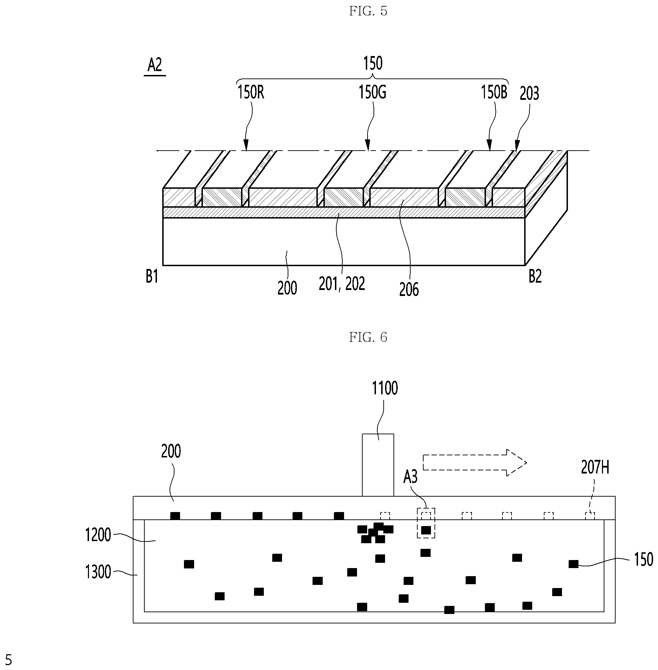

FIG. 5 is an enlarged view of an area A2 of FIG. 4.

Referring to FIG. 5, the display device 100 of the embodiment may comprise a substrate 200, assembling wirings 201 and 202, an insulating layer 206, and a plurality of semiconductor light-emitting devices 150. More components may be included.

The assembling wiring may comprise a first assembling wiring 201 and a second assembling wiring 202 that are spaced apart from each other. The first assembling wiring 201 and the second assembling wiring 202 may be provided to generate a dielectrophoretic force (DEP force) to assemble the semiconductor light-emitting device 150. For example, the semiconductor light-emitting device 150 may be one of a lateral type semiconductor light-emitting device, a flip-chip type semiconductor light-emitting device, and a vertical type semiconductor light-emitting device.

The semiconductor light-emitting device 150 may comprise a red semiconductor light-emitting device 150R, a green semiconductor light-emitting device 150G, and a blue semiconductor light-emitting device 150B to form a unit pixel (sub-pixel), but is not limited thereto, and may implement red and green colors, respectively, by providing a red phosphor and a green phosphor.

The substrate 200 may be a supporting member that supports components disposed on the substrate 200 or a protective member that protects the components.

The substrate 200 may be a rigid substrate or a flexible substrate. The substrate 200 may be formed of sapphire, glass, silicon, or polyimide. In addition, the substrate 200 may comprise a flexible material such as polyethylene naphthalate (PEN) or polyethylene terephthalate (PET). In addition, the substrate 200 may be a transparent material, but is not limited thereto. The substrate 200 may function as a support substrate in a display panel, and may also function as an assembling substrate when self-assembling light-emitting devices.

The substrate 200 may be a backplane equipped with circuits, such as transistors ST and DT, capacitors Cst, signal wiring, etc. within the sub-pixels PX1, PX2, and PX3 illustrated in FIGS. 2 and 3, but is not limited thereto.

The insulating layer 206 may comprise an insulating and flexible organic material such as polyimide, PAC, PEN, PET, polymer, or an inorganic material such as silicon oxide (SiO₂) or silicon nitride series (SiNₓ), and may be formed integrally with the substrate 200 to form a single substrate.

The insulating layer 206 may be a conductive adhesive layer having adhesiveness and conductivity, and the conductive adhesive layer may have flexibility to enable a flexible function of the display device. For example, the insulating layer 206 may be a conductive adhesive layer such as an anisotropic conductive film (ACF) or an anisotropic conductive medium, a solution containing conductive particles, etc. The conductive adhesive layer may be a layer that is electrically conductive in a vertical direction relative to the thickness, but electrically insulating in a horizontal direction relative to the thickness.

The insulating layer 206 may comprise an assembly hole 203 for inserting a semiconductor light-emitting device 150. Therefore, during self-assembly, the semiconductor light-emitting device 150 may be easily inserted into the assembly hole 203 of the insulating layer 206. The assembly hole 203 may be called an insertion hole, a fixing hole, an alignment hole, etc. The assembly hole 203 may also be called a hole.

The assembly hole 203 may be called a hole, a groove, a recess, a pocket, etc.

The assembly hole 203 may be different depending on the shape of the semiconductor light-emitting device 150. For example, the red semiconductor light-emitting device, the green semiconductor light-emitting device, and the blue semiconductor light-emitting device each have different shapes, and may have an assembly hole 203 having a shape corresponding to each shape of these semiconductor light-emitting devices. For example, the assembly hole 203 may comprise a first assembly hole for assembling the red semiconductor light-emitting device, a second assembly hole for assembling the green semiconductor light-emitting device, and a third assembly hole for assembling the blue semiconductor light-emitting device. For example, the red semiconductor light-emitting device may have a circular shape, the green semiconductor light-emitting device may have a first elliptical shape having a first minor axis and a first major axis, and the blue semiconductor light-emitting device may have a second elliptical shape having a second minor axis and a second major axis, but is not limited thereto. The second major axis of the elliptical shape of the blue semiconductor light-emitting device may be longer than the second major axis of the elliptical shape of the green semiconductor light-emitting device, and the second minor axis of the elliptical shape of the blue semiconductor light-emitting device may be shorter than the first minor axis of the elliptical shape of the green semiconductor light-emitting device.

Meanwhile, the method of mounting the semiconductor light-emitting device 150 on the substrate 200 may comprise, for example, a self-assembly method (FIG. 6) and a transfer method.

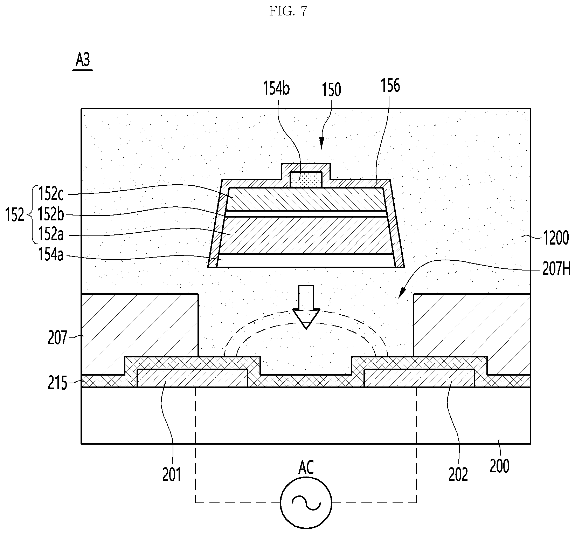

FIG. 6 is a drawing showing an example of assembling a light-emitting device according to an embodiment on a substrate by a self-assembly method, and FIG. 7 is a partial enlarged view of the A3 region of FIG. 6. FIG. 7 is a drawing in which the A3 region is rotated by 180 degrees for convenience of explanation.

Based on FIG. 6 and FIG. 7, an example of assembling semiconductor light-emitting devices according to an embodiment on a display panel by a self-assembly method using an electromagnetic field will be described.

The assembling substrate 200 described below can also function as a panel substrate 200a in a display device after assembling the light-emitting devices, but is not limited thereto.

Referring to FIG. 6, the semiconductor light-emitting devices 150 can be introduced into a chamber 1300 filled with a fluid 1200, and the semiconductor light-emitting devices 150 can be moved to the assembling substrate 200 by a magnetic field generated from the assembly device 1100. At this time, the light-emitting devices 150 adjacent to the assembly holes 207H of the assembling substrate 200 can be assembled into the assembly holes 207H by the DEP force caused by the electric field of the assembling wirings. The fluid 1200 can be water such as ultrapure water, but is not limited thereto. The chamber can be called a tank, a container, a vessel, etc.

After the semiconductor light-emitting devices 150 is introduced into the chamber 1300, the assembling substrate 200 may be disposed on the chamber 1300. Depending on the embodiment, the assembling substrate 200 may be introduced into the chamber 1300.

Referring to FIG. 7, the semiconductor light-emitting device 150 may be implemented as a vertical type semiconductor light-emitting device as illustrated, but is not limited thereto, and a lateral type light-emitting device may be employed.

The semiconductor light-emitting device 150 may comprise a magnetic layer (not illustrated) having a magnetic substance. The magnetic layer may comprise a metal having magnetism, such as nickel (Ni). Since the semiconductor light-emitting device 150 introduced into the fluid comprises a magnetic layer, it may move to the assembling substrate 200 by a magnetic field generated from the assembly device 1100. The magnetic layer may be disposed on the upper or lower side or both sides of the light-emitting device.

The semiconductor light-emitting device 150 may comprise a passivation layer 156 surrounding the upper surface and the side surface. The passivation layer 156 may be formed by using an inorganic insulator such as silica, alumina, etc. through PECVD, LPCVD, sputtering deposition, etc. In addition, the passivation layer 156 may be formed by using a method of spin coating an organic material such as a photoresist or a polymer material.

The semiconductor light-emitting device 150 may comprise a first conductivity type semiconductor layer 152a, a second conductivity type semiconductor layer 152c, and an active layer 152b disposed therebetween. The first conductivity type semiconductor layer 152a may be an n-type semiconductor layer, and the second conductivity type semiconductor layer 152c may be a p-type semiconductor layer, but is not limited thereto. The first conductivity type semiconductor layer 152a, the second conductivity type semiconductor layer 152c, and the active layer 152b disposed therebetween can constitute a light-emitting structure 152. The light-emitting structure 152 can be called a light-emitting layer, a light-emitting region, etc.

The first electrode (layer) 154a can be disposed under the first conductivity type semiconductor layer 152a, and the second electrode (layer) 154b can be disposed on the second conductivity type semiconductor layer 152c. To this end, a part of the first conductivity type semiconductor layer 152a or the second conductivity type semiconductor layer 152c can be exposed to the outside. Accordingly, after the semiconductor light-emitting device 150 is assembled on the assembling substrate 200, a part of the passivation layer 156 can be etched in the manufacturing process of the display device.

The first electrode 154a can comprise at least one or more layer. For example, the first electrode 154a may comprise an ohmic layer, a reflective layer, a magnetic layer, a conductive layer, an anti-oxidation layer, an adhesive layer, etc. The ohmic layer may comprise Au, AuBe, etc. The reflective layer may comprise Al, Ag, etc. The magnetic layer may comprise Ni, Co, etc. The conductive layer may comprise Cu, etc. The anti-oxidation layer may comprise Mo, etc. The adhesive layer may comprise Cr, Ti, etc.

The second electrode 154b may comprise a transparent conductive layer. For example, the second electrode 154b may comprise ITO, IZO, etc.

The assembling substrate 200 may comprise a pair of first assembling wirings 201 and second assembling wirings 202 corresponding to each of the semiconductor light-emitting devices 150 to be assembled. Each of the first assembling wirings 201 and the second assembling wirings 202 may be formed by multiply laminating a single metal or a metal alloy, a metal oxide, etc. For example, each of the first assembling wiring 201 and the second assembling wiring 202 may be formed by comprising at least one of Cu, Ag, Ni, Cr, Ti, Al, Rh, Pd, Ir, Ru, Mg, Zn, Pt, Au, and Hf, but is not limited thereto.

In addition, each of the first assembling wiring 201 and the second assembling wiring 202 may be formed by comprising at least one of indium tin oxide (ITO), indium zinc oxide (IZO), indium zinc tin oxide (IZTO), indium aluminum zinc oxide (IAZO), indium gallium zinc oxide (IGZO), indium gallium tin oxide (IGTO), aluminum zinc oxide (AZO), antimony tin oxide (ATO), gallium zinc oxide (GZO), IZO nitride (IZON), Al-Ga ZnO (AGZO), In-Ga ZnO (IGZO), ZnO, IrOx, RuOx, NiO, RuOx/ITO, Ni/IrOx/Au, and Ni/IrOx/Au/ITO, but is not limited thereto.

The first assembling wiring 201 and the second assembling wiring 202 form an electric field when an AC voltage is applied, and the semiconductor light-emitting device 150 inserted into the assembly hole 207H can be fixed by the DEP force caused by the electric field. The gap between the first assembling wiring 201 and the second assembling wiring 202 can be smaller than the width of the semiconductor light-emitting device 150 and the width of the assembly hole 207H, and the assembly position of the semiconductor light-emitting device 150 can be fixed more precisely using the electric field.

An insulating layer 215 may be formed on the first assembling wiring 201 and the second assembling wiring 202 to protect the first assembling wiring 201 and the second assembling wiring 202 from the fluid 1200 and prevent leakage of current flowing in the first assembling wiring 201 and the second assembling wiring 202. For example, the insulating layer 215 may be formed as a single layer or multiple layers of an inorganic insulator such as silica or alumina or an organic insulator. The insulating layer 215 may have a minimum thickness to prevent damage to the first assembling wiring 201 and the second assembling wiring 202 when assembling the semiconductor light-emitting device 150, and may have a maximum thickness to stably assemble the semiconductor light-emitting device 150.

A partition wall 207 may be formed on the upper part of the insulating layer 215. Some areas of the partition wall 207 may be located on the upper part of the first assembling wiring 201 and the second assembling wiring 202, and the remaining areas may be located on the upper part of the assembling substrate 200.

Meanwhile, when manufacturing the assembling substrate 200, some of the partition walls formed on the upper part of the insulating layer 215 may be removed, thereby forming an assembly hole 207H in which each of the semiconductor light-emitting devices 150 is coupled and assembled to the assembling substrate 200.

An assembly hole 207H can be formed in the assembling substrate 200 to which semiconductor light-emitting devices 150 are combined, and the surface where the assembly hole 207H is formed can be in contact with the fluid 1200. The assembly hole 207H can guide the exact assembly position of the semiconductor light-emitting device 150.

Meanwhile, the assembly hole 207H can have a shape and size corresponding to the shape of the semiconductor light-emitting device 150 to be assembled at the corresponding position. Accordingly, it is possible to prevent another semiconductor light-emitting device from being assembled in the assembly hole 207H or a plurality of semiconductor light-emitting devices from being assembled.

Referring again to 6, after the assembling substrate 200 is disposed in the chamber, an assembly device 1100 that applies a magnetic field can move along the assembling substrate 200. The assembly device 1100 can be a permanent magnet or an electromagnet.

The assembly device 1100 may move in contact with the assembling substrate 200 to maximize the area of the magnetic field applied to the fluid 1200. Depending on the embodiment, the assembly device 1100 may comprise a plurality of magnetic bodies or may comprise a magnetic body of a size corresponding to the assembling substrate 200. In this case, the movement distance of the assembly device 1100 may be limited within a predetermined range.

The semiconductor light-emitting device 150 in the chamber 1300 may move toward the assembly device 1100 and the assembling substrate 200 by the magnetic field generated by the assembly device 1100.

Referring to FIG. 7, the semiconductor light-emitting device 150 may enter the assembly hole 207H and be fixed by the DEP force formed by the electric field between the assembling wirings 201 and 202 while moving toward the assembly device 1100.

Specifically, the first and second assembling wirings 201 and 202 form an electric field by an AC power source, and a DEP force can be formed between the assembling wirings 201 and 202 by the electric field. The semiconductor light-emitting device 150 can be fixed to the assembly hole 207H on the assembling substrate 200 by the DEP force.

At this time, a predetermined solder layer (not shown) is formed between the light-emitting device 150 assembled on the assembly hole 207H of the assembling substrate 200 and the assembling wirings 201 and 202, thereby improving the bonding strength of the light-emitting device 150.

In addition, a molding layer (not shown) can be formed in the assembly hole 207H of the assembling substrate 200 after assembly. The molding layer can be a transparent resin or a resin containing a reflective material or a scattering material.

Since the time required for each semiconductor light-emitting device to be assembled on the substrate can be drastically shortened by the self-assembly method using the electromagnetic field described above, a large-area, high-pixel display can be implemented more quickly and economically.

Meanwhile, although not shown, a Vdd line can be disposed between the first assembling wiring 201 and the second assembling wiring 202, and can be used as an electrode wiring for electrically contacting the semiconductor light-emitting device 150.

However, as the semiconductor light-emitting device 150 is miniaturized, the gap between the first assembling wiring 201 and the second assembling wiring 202 also narrows, and when the gap between the first assembling wiring 201 and the second assembling wiring 202 narrows, a problem may occur in which the first assembling wiring 201 or the second assembling wiring 202 is electrically shorted with the Vdd line.

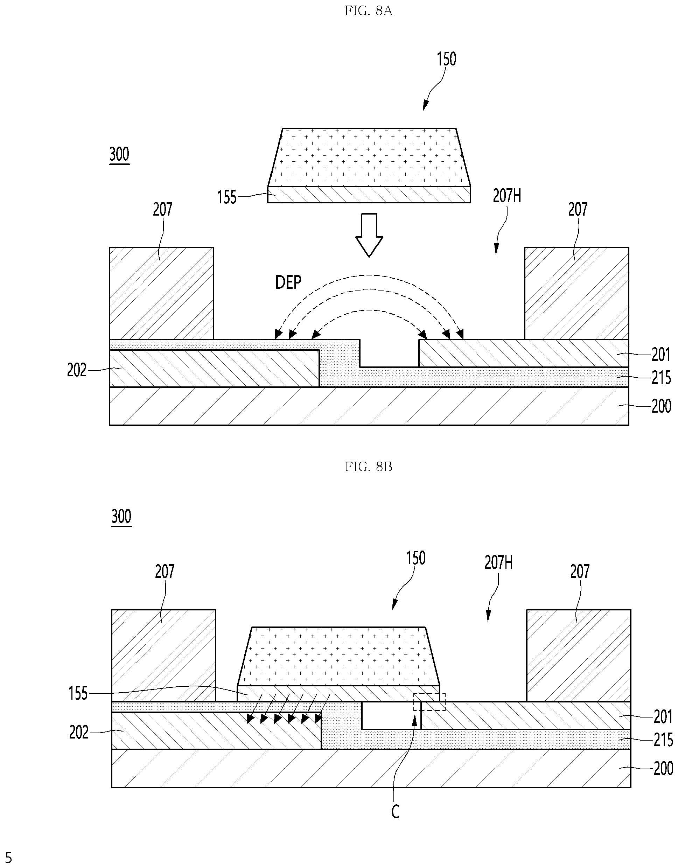

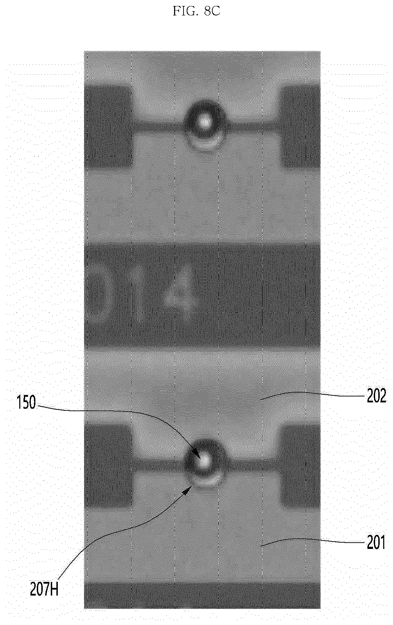

Next, FIGS. 8A to 8B are examples of self-assembly in a display device 300 according to internal technology, and FIG. 8C is a self-assembly photo in a display device according to internal technology.

In the display device 300 according to internal technology, either the first assembling wiring 201 or the second assembling wiring 202 and the bonding metal 155 of the semiconductor light-emitting device 150 are contacted through a bonding process.

However, in order to solve the problem that the bonding area is reduced as the semiconductor light-emitting device 150 is miniaturized, as shown in FIGS. 8A to 8B, an existing Vdd line is omitted and its role is opened to one side of the assembling wiring, for example, the first assembling wiring 201. Since the Vdd line is omitted, the gap between the first assembling wiring 201 and the second assembling wiring 202 can be further narrowed, which can easily respond to miniaturization of the semiconductor light-emitting device 150.

However, when this method is used, the semiconductor light-emitting device 150 drawn to the first assembling wiring 201 by the DEP in the fluid comes into contact with the first assembling wiring 201 and becomes conductive. Accordingly, there is a problem that the electric field force is concentrated on the second assembling wiring 202 that is not opened by the insulating layer 215, resulting in assembly being biased in one direction.

Referring to FIGS. 8B and 8C, the contact area C between the bonding metal 155 of the semiconductor light-emitting device 150 and the first assembling wiring 201 that functions as a panel electrode is very small, which can cause poor contact.

That is, according to the non-public internal technology, DEP force is required for self-assembly, but due to the difficulty in uniform control of DEP force, there is a problem that the semiconductor light-emitting device is tilted to a place other than the normal position within the assembly hole 207H when assembling using self-assembly.

In addition, due to the tilting phenomenon of the semiconductor light-emitting device, the electrical contact characteristics can be deteriorated in the subsequent electrical contact process, resulting in poor lighting rate and reduced yield.

Therefore, according to the non-public internal technology, DEP force is required for self-assembly, but when using DEP force, there is a technical contradiction in that the electrical contact characteristics are deteriorated due to the tilting phenomenon of the semiconductor light-emitting device.

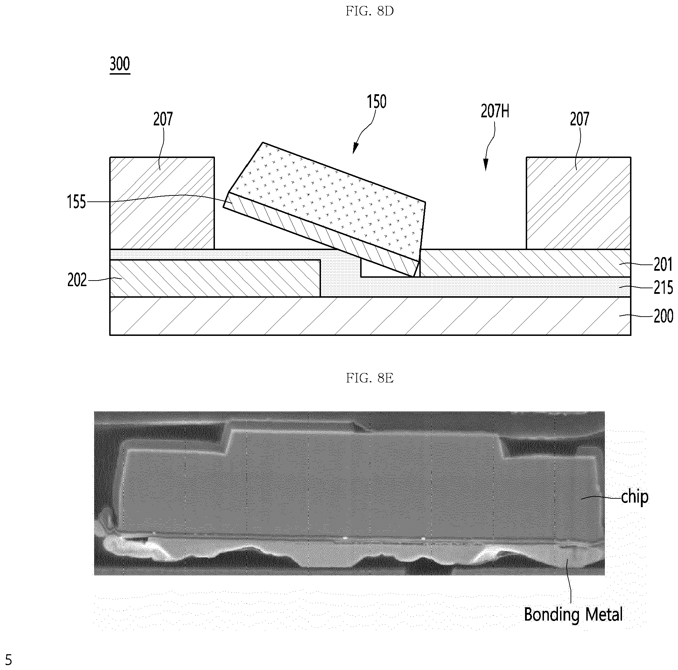

Next, FIG. 8D is a drawing showing a tilt phenomenon that may occur during self-assembly according to the internal technology.

According to the internal technology, an insulating layer 215 is disposed on the first and second assembling wirings 201 and 202 on the assembling substrate 200, and self-assembly of the semiconductor light-emitting device 150 by DEP force is performed in the assembly hole 207H set by the partition wall 207. However, according to the internal technology, there is a problem in that the electric field force is concentrated on the second assembling wiring 202, resulting in assembly being biased in one direction, and as a result, self-assembly is not performed properly and a problem in which the self-assembly is tilted within the assembly hole 207H has been studied.

In addition, FIG. 8E is a focused ion beam (FIB) photograph of a light-emitting device (chip) and a bonding metal in a display panel according to the internal technology, and FIG. 8f is lighting data in the display panel according to the internal technology.

As shown in FIG. 8E, in the semiconductor light-emitting device according to the internal technology, the bottom bonding metal has poor surface morphology, and the contact characteristics between the bottom bonding metal of the light-emitting device and the panel wiring are poor, resulting in poor lighting.

In addition, according to the internal technology, the bottom bonding metal comes into direct contact with the assembling wiring 201 and 202, and poor electrical contact occurs due to the surface unevenness of the bonding metal.

In the internal technology, the electrode layer of the light-emitting device can be made of materials such as Ti, Cu, Pt, Ag, and Au, but when a bonding metal of materials such as Sn or In is formed on the electrode layer of such materials, the surface becomes uneven due to clumping phenomenon, etc.

Meanwhile, in order to improve the surface characteristics of the bonding metal in the internal technology, the deposition speed was increased, but even if the clumping phenomenon was partially alleviated, another problem was discovered in which the grain size decreased as the deposition speed increased, resulting in a decrease in contact force, and it was not easy to improve the surface characteristics of the bonding metal.

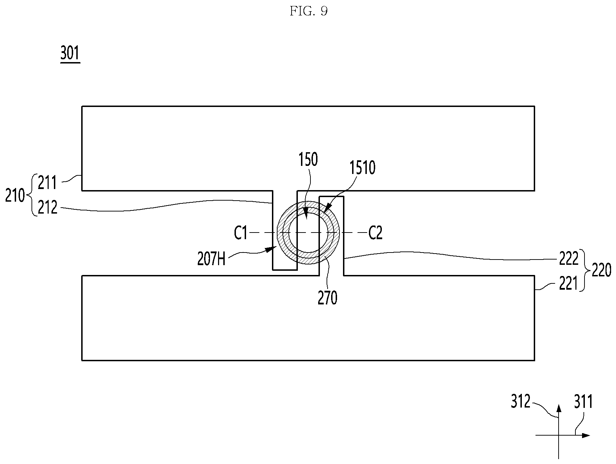

Hereinafter, various embodiments for solving the above-described problem will be described with reference to FIGS. 9 to 19. Any descriptions omitted below can be easily understood from the descriptions given above with respect to FIGS. 1 to 8 and the corresponding drawings.

### [First Embodiment]

FIG. 9 is a plan view illustrating a display device according to a first embodiment. FIG. 10 is a cross-sectional view taken along the C1-C2 line of FIG. 9.

Referring to FIGS. 9 and 10, the display device 301 according to the first embodiment may comprise a substrate 200, a first assembling wiring 210, a second assembling wiring 220, a partition wall 207, a semiconductor light-emitting device 150, and a connection electrode 270. The display device 301 according to the first embodiment may comprise more components than these.

The substrate 200 can be used as an assembling substrate for assembling semiconductor light-emitting devices 150 during the self-assembly process, and can be used as a display substrate for supporting various components and displaying images when the product is shipped.

A plurality of pixels may be included on the substrate 200. FIG. 9 and FIG. 10 illustrate one pixel among the plurality of pixels, and each of the plurality of pixels may have the same structure illustrated in FIG. 9 and FIG. 10. However, the semiconductor light-emitting devices 150 disposed in the plurality of sub-pixels included in each of the plurality of pixels may emit light of different colors. For example, the semiconductor light-emitting device 150 may comprise a first semiconductor light-emitting device disposed in a first sub-pixel that emits a first color light, a second semiconductor light-emitting device disposed in a second sub-pixel that emits a second color light, and a third semiconductor light-emitting device disposed in a third sub-pixel that emits a third color light. For example, the first color light may be red light, the second color light may be green light, and the third color light may be blue light, but is not limited thereto.

The first assembling wiring 210 and the second assembling wiring 220 may be disposed on the substrate 200. For example, the first assembling wiring 210 and the second assembling wiring 220 may be disposed on the same layer.

Meanwhile, as illustrated in FIG. 9, a part of the first assembling wiring 210 and a part of the second assembling wiring 220 may be disposed in parallel so as to face each other. An assembly hole 207H may be positioned on a part of the first assembling wiring 210 and a part of the second assembling wiring 220. For example, the assembly hole 207H may be formed in the partition wall 207. The assembly hole 207H may be a hole for assembling the semiconductor light-emitting device 150, and may also be referred to as a hole.

The first assembling wiring 210 may comprise a first bus wiring 211 and a first branch electrode 212. The first bus wiring 211 may be disposed along a first direction 311. The first branch electrode 212 may extend from the first bus wiring 211 along a second direction 312.

The second assembling wiring 220 may comprise a second bus wiring 221 and a second branch electrode 222. The second bus wiring 221 may be disposed along the first direction 311. The second bus wiring 221 may be disposed spaced apart from the first bus wiring 211 and in parallel with the first bus wiring 211. The second branch electrode 222 may extend from the second bus wiring 221 along the second direction 312. The second branch electrode 222 may extend from the second bus wiring 221 toward the first bus wiring 211.

For example, the width of the first bus wiring 211 and the width of the second bus wiring 221 may be the same, but is not limited thereto.

Each of the first branch electrode 212 and the second branch electrode 222 may be called a bar electrode, a rod electrode, a string electrode, etc.

For example, the first branch electrode 212 may extend from the first bus wiring 211 through a first inner side 231 of the assembly hole 207H toward the second bus wiring 221. For example, the second branch electrode 222 may extend from the second bus wiring 221 through a second inner side 232 of the assembly hole 207H toward the first bus wiring 211. In this case, the first branch electrode 212 and the second branch electrode 222 may be disposed parallel to each other in the assembly hole 207H.

Although the drawing illustrates that the first branch electrode 212 does not overlap the second bus wiring 221 and that the second branch electrode 222 does not overlap the first bus wiring 211, but is not limited thereto. That is, the first branch electrode 212 may extend from the first bus wiring 211 and overlap with a part of the second bus wiring 221. The second branch electrode 222 may extend from the second bus wiring 221 and overlap with a part of the first bus wiring 211.

Meanwhile, the partition wall 207 may be disposed on the first assembling wiring 210 and the second assembling wiring 220. The partition wall 207 may have an assembly hole 207H. A semiconductor light-emitting device 150 may be disposed in the assembly hole 207H. That is, the semiconductor light-emitting device 150 may be inserted into the assembly hole 207H.

The assembly hole 207H may be formed in each of the plurality of sub-pixels of each of the plurality of pixels. Accordingly, the semiconductor light-emitting device 150 may be disposed in each of the plurality of sub-pixels of each of the plurality of pixels. As described above, the semiconductor light-emitting devices 150 disposed in the plurality of sub-pixels included in each of the plurality of pixels can emit light of different colors. The color light may be red light, green light, blue light, etc., but is not limited thereto.

The shape of the assembly hole 207H may be formed in consideration of the shape of the semiconductor light-emitting device 150. For example, the assembly hole 207H may have a shape corresponding to the shape of the semiconductor light-emitting device 150. For example, when the semiconductor light-emitting device 150 has a circular shape, the assembly hole 207H may also have a circular shape. When the semiconductor light-emitting device 150 has an oval shape, the assembly hole 207H may also have an oval shape. Since the semiconductor light-emitting device 150 must be inserted into the assembly hole 207H, the size of the assembly hole 207H is made larger than the size of the semiconductor light-emitting device 150, so that when the semiconductor light-emitting device 150 is inserted into the assembly hole 207H, the outer side of the semiconductor light-emitting device 150 can be spaced apart from the inner side surface of the assembly hole 207H.

Meanwhile, the semiconductor light-emitting device 150 can be disposed in the assembly hole 207H.

The semiconductor light-emitting device 150 of the embodiment can have a step difference part 1510.

The semiconductor light-emitting device 150 can comprise a first conductivity type semiconductor layer 152a, an active layer 152b, a second conductivity type semiconductor layer 152c, a first electrode 154a, a second electrode 154b, and a passivation layer 156. The first conductivity type semiconductor layer 152a, the active layer 152b, and the second conductivity type semiconductor layer 152c can form the light-emitting structure 152. These components 152a, 152b, 152c, 154a, 154b and 156 of the semiconductor light-emitting device 150 can be easily understood from the description of the components of the semiconductor light-emitting device 150 illustrated in FIG. 7, and thus, a detailed description thereof will be omitted.

The step difference part 1510 can be disposed on a side portion of the first conductivity type semiconductor layer 152a. For example, the step difference part 1510 can be disposed along the perimeter of the side portion of the first conductivity type semiconductor layer 152a, but is not limited thereto.

The first conductivity type semiconductor layer 152a may comprise a first-first conductivity type semiconductor layer 1521 and a first-second conductivity type semiconductor layer 1522.

The conductivity type semiconductor layer may have a first width W1, and the first-second conductivity type semiconductor layer may have a second width W2. The second width W2 may be smaller than the first width W1.

In this case, the step difference part 1510 may comprise a first-first side region 1511, a bottom region 1513, and a first-second side region 1512.

For example, the first-first side region 1511 may be disposed on the side portion of the first-first conductivity type semiconductor layer. That is, the first-first side region 1511 may be disposed along the perimeter of the side portion of the first-first conductivity type semiconductor layer. The first-second side region 1512 may be disposed on the side portion of the first-second conductivity type semiconductor layer. That is, the first-second side region 1512 may be disposed along the perimeter of the side portion of the first-second conductivity type semiconductor layer. The bottom region 1513 may be disposed on an upper side of the first-first conductivity type semiconductor layer between the first-first side region 1511 and the first-second side region 1512.

The side region 1511 and the first-second side region 1512 may have an inclined surface inclined with respect to a lower surface of the semiconductor light-emitting device 150. The inclination angle of the first-first side region 1511 and the inclination angle of the first-second side region 1512 may be the same, but are not limited thereto. The bottom region 1513 may have a surface parallel to the lower surface of the semiconductor light-emitting device 150, but are not limited thereto.

Meanwhile, the connection electrode 270 may be disposed in the assembly hole 207H. For example, the connection electrode 270 may electrically connect the semiconductor light-emitting device 150 and the first assembling wiring 210 and the second assembling wiring 220 in the assembly hole 207H. Although not shown, the connection electrode 270 may also be connected to the first assembling wiring 210 or the second assembling wiring 220. For example, one side of the connection electrode 270 may be electrically connected to a side portion of the semiconductor light-emitting device 150, and the other side of the connection electrode 270 may be electrically connected to a part of the upper surface of the first assembling wiring 210 and/or the second assembling wiring 220. For example, since the connection electrode 270 is formed along the perimeter of the side portion of the semiconductor light-emitting device 150, the connection electrode 270 can be electrically connected to the semiconductor light-emitting device 150 along the perimeter of the side portion of the semiconductor light-emitting device 150.

According to the internal technology (FIG. 7), the first electrode 154a of the semiconductor light-emitting device 150 is provided on the lower side, but an insulating layer 215 is disposed on the first assembling wiring 201 and/or the second assembling wiring 202, so that the electrical connection process between the first electrode 154a of the semiconductor light-emitting device 150 and the first assembling wiring 201 and/or the second assembling wiring 202 through the insulating layer 215 may not be easy.

According to the internal technology (FIGS. 8A and 8B), even if the first assembling wiring 201 is exposed and electrically connected to the lower side of the semiconductor light-emitting device 150, the electrical connection process between the lower side of the semiconductor light-emitting device 150 and the first assembling wiring 201 may still not be easy. In addition, when the semiconductor light-emitting device 150 moves from the assembly hole 207H toward the second assembling wiring 202 due to an imbalance in the DEP force during self-assembly, a contact failure occurs between the semiconductor light-emitting device 150 and the first assembling wiring 201, resulting in a deterioration in electrical contact characteristics. Accordingly, there is a problem that a lighting rate failure occurs and a yield decreases.

However, according to the first embodiment, instead of removing the insulating layer 215 under the semiconductor light-emitting device 150, the insulating layer 215 around the semiconductor light-emitting device 150 is removed, and the connection electrode 270 can be connected to the first assembling wiring 210 and/or the second assembling wiring 220 exposed by the removal of the insulating layer 215. Accordingly, since the insulating layer 215 can be easily removed, the electrical connection process between the semiconductor light-emitting device 150 and the first assembling wiring 210 and/or the second assembling wiring 220 can be easily performed, thereby preventing process defects.

In addition, since the connection electrode 270 of the first embodiment is electrically connected to the semiconductor light-emitting device 150 along the perimeter of the side portion of the semiconductor light-emitting device 150, the contact area between the semiconductor light-emitting device 150 and the first assembling wiring and/or the second assembling wiring 220 can be expanded, thereby improving electrical characteristics and optical properties.

As shown in FIG. 13, when a forward bias voltage is applied, a larger current flows in the first embodiment compared to the comparative example, so it can be seen that the electrical characteristics of the display device 301 according to the first embodiment are improved.

The comparative example is a display device according to the internal technology (FIGS. 8A and 8B), and the embodiment may be a display device 301 according to the first embodiment.

As shown in FIG. 13, since a step difference part 1510 is formed on the side portion of the semiconductor light-emitting device 150, and a connection electrode 270 is disposed on the step difference part 1510, the electrical contact area between the connection electrode 270 and the semiconductor light-emitting device 150 is expanded, so that a larger current can flow in the semiconductor light-emitting device 150. Since a larger current flows through the semiconductor light-emitting device 150, the luminance of the semiconductor light-emitting device (150) can be increased and a lower voltage can be applied, enabling low-voltage operation and reducing power consumption. In addition, since poor contact between the semiconductor light-emitting device 150 and the connection electrode 270 does not occur, lighting is possible in all pixels and all sub-pixels as shown in FIG. 14, thus preventing poor lighting rates and improving yield.

Referring again to FIG. 10, the connection electrode 270 can be disposed on a step difference part 1510 provided on the side portion of the semiconductor light-emitting device 150.

For example, the connection electrode 270 can contact a part of the upper surface of the first assembling wiring 210 and/or the second assembling wiring 220 through the insulating layer 215.

For example, the connection electrode 270 may be in contact with the side portion of the first electrode 154a of the semiconductor light-emitting device 150.

As described above, the step difference part 1510 may comprise a first-first side region 1511, a bottom region 1513, and a first-second side region 1512. In this case, the connection electrode 270 may be in contact with the first-first side region 1511 and the bottom region 1513.

The connection electrode 270 may be in contact with a part of the bottom region 1513 and may be spaced apart from the first-second side region 1512. In this case, the passivation layer 156 may be disposed between the first-first side region 1511 and the connection electrode 270, so that an electrical short between the connection electrode 270 and the active layer 152b can be prevented by the passivation layer 156.

Therefore, the connection electrode 270 may be in contact with not only the upper surface of the first assembling wiring 210 and/or the second assembling wiring 220, but also the inner side surface of the insulating layer 215, the side portion of the first electrode 154a, the first-first side region 1511 of the step difference part 1510, and the bottom region 1513 of the step difference part 1510, so that the semiconductor light-emitting device 150 can be more firmly fixed, thereby improving product reliability.

Meanwhile, the connection electrode 270 may comprise at least one or more layer. For example, the connection electrode 270 may comprise a metal having excellent electrical conductivity, high reflectivity, or high thermal conductivity. The connection electrode 270 may comprise aluminum (Al) or silver (Ag). The aluminum (Al) may be easily oxidized. Accordingly, the connection electrode 270 may comprise molybdenum (Mo) to prevent oxidation of aluminum (Al).

The connection electrode 270 may comprise a first layer, a second layer, and a third layer. The first layer may be disposed below the second layer, and the third layer may be disposed on the second layer. For example, the second layer may comprise aluminum or silver. At least one of the first layer or the second layer may comprise molybdenum.

According to the first embodiment, the connection electrode 270 may be disposed on the side portion of the first conductivity type semiconductor layer 152a of the semiconductor light-emitting device 150 as well as the step difference part 1510, so that light within the semiconductor light-emitting device 150 can be reflected by the connection electrode 270, thereby increasing the light efficiency of the semiconductor light-emitting device 150 to improve the light output or the luminance.

According to the first embodiment, since the thermal conductivity of the connection electrode 270 is high, heat generated in the semiconductor light-emitting device 150 can be quickly released to the outside through the connection electrode 270, the first assembling wiring 210, and the second assembling wiring 220, so that the heat dissipation characteristics can be improved, the lifespan is extended, and thermal fatigue can be improved.

Meanwhile, according to the first embodiment, since the electrical contact on the lower side of the semiconductor light-emitting device 150 is made through the side portion of the semiconductor light-emitting device 150 using the connection electrode 270, the solder metal for the electrical contact on the lower side of the semiconductor light-emitting device 150 is not required, so that not only can the material cost be reduced, but also various defects or failures due to the use of the solder metal can be prevented.

Meanwhile, the display device 301 according to the first embodiment may comprise a first insulating layer 215, a second insulating layer 250, and an electrode wiring 260.

The first insulating layer 215 may be disposed on the first assembling wiring 210 and the second assembling wiring 220, so as to protect the first assembling wiring 210 and the second assembling wiring 220 from the fluid, and prevent leakage of current flowing in the first assembling wiring 210 and the second assembling wiring 220.

The second insulating layer 250 may be disposed on the partition wall 207. The second insulating layer 250 may be disposed on the entire area of the substrate 200, and may be disposed not only on the partition wall 207 but also within the assembly hole 207H. The second insulating layer 250 may cover the semiconductor light-emitting device 150 disposed within the assembly hole 207H, thereby reinforcing the fixation of the semiconductor light-emitting device 150. In addition, the second insulating layer 250 may protect the semiconductor light-emitting device 150 from external foreign substances or external impacts by covering the semiconductor light-emitting device 150 disposed within the assembly hole 207H. The second insulating layer 250 may comprise an organic material or an inorganic material.

The electrode wiring 260 may be disposed on the second insulating layer 250. The electrode wiring 260 may be used as an electrode for supplying voltage to the semiconductor light-emitting device 150. For this purpose, the electrode wiring 260 may be electrically connected to the upper side of the semiconductor light-emitting device 150 through the second insulating layer 250.

Meanwhile, the second assembling wiring 220, i.e., the second branch electrode 222, may also be used as an electrode for supplying voltage to the semiconductor light-emitting device 150.

For convenience, when the semiconductor light-emitting device 150 emits light to display an image, the second assembling wiring 220 may be used as a lower electrode wiring, and the electrode wiring 260 disposed on the partition wall207 may be used as an upper electrode wiring.

For example, one of the lower electrode wiring 220 and the upper electrode wiring 260 may be a common electrode wiring that is commonly connected to a plurality of sub-pixels of each of a plurality of pixels.

The lower electrode wiring 220 may be called the first electrode wiring, and the upper electrode wiring 260 may be called the second electrode wiring. For example, the upper electrode wiring 260 may be used as the common electrode wiring. In this case, light having different luminance may be emitted from each of the plurality of sub-pixels of each of the plurality of pixels by different voltages applied to the lower electrode wiring 220, i.e., the second branch electrode 222, which is disposed in each of the plurality of sub-pixels of each of the plurality of pixels, and thus, an image having different gray-scales may be displayed from each of the plurality of sub-pixels of each of the plurality of pixels by the light having different luminance.

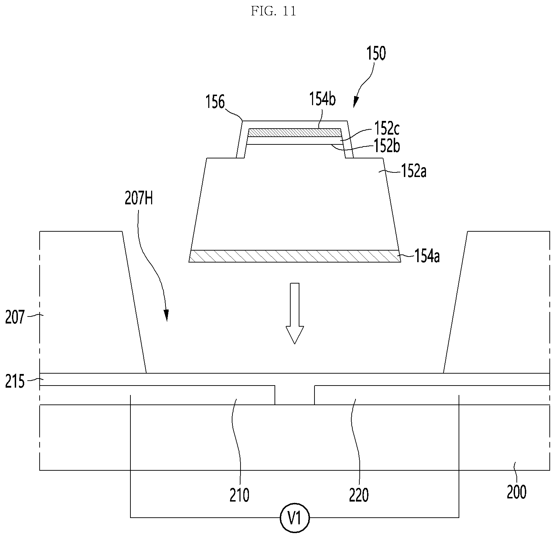

FIG. 11 illustrates an assembly process of a semiconductor light-emitting device.

As illustrated in FIG. 11, a substrate 200 may be mounted in a chamber (1300 of FIG. 6) for a self-assembly process.

Next, an AC voltage V1 may be applied to the first branch electrode 212 of the first assembling wiring 210 and the second branch electrode 222 of the second assembling wiring 220, so that a DEP force can be formed between the first branch electrode 212 and the second branch electrode 222.

As illustrated in FIG. 9, the first branch electrode 212 and the second branch electrode 222 may be disposed to face each other, so that a DEP force can be formed between the first branch electrode 212 and the second branch electrode 222.

Next, as the assembly device 1100 moves along the substrate 200, the semiconductor light-emitting devices 150 in the fluid 1200 may be moved by the assembly device 1100, and when these semiconductor light-emitting devices 150 pass through the assembly hole 207H of the substrate 200, they can be inserted into the assembly hole 207H by the DEP force within the assembly hole 207H.

Next, the semiconductor light-emitting device 150 inserted into the assembly hole 207H can be positioned correctly without being tilted to one side within the assembly hole 207H by the DEP force. Since the first branch electrode 212 and the second branch electrode 222 are disposed on the same layer, a uniform DEP force can be formed between the first branch electrode 212 and the second branch electrode 222 along the horizontal direction. In this way, the semiconductor light-emitting device 150 inserted into the assembly hole 207H can be fixed in the normal position within the assembly hole 207H by the uniform DEP force.

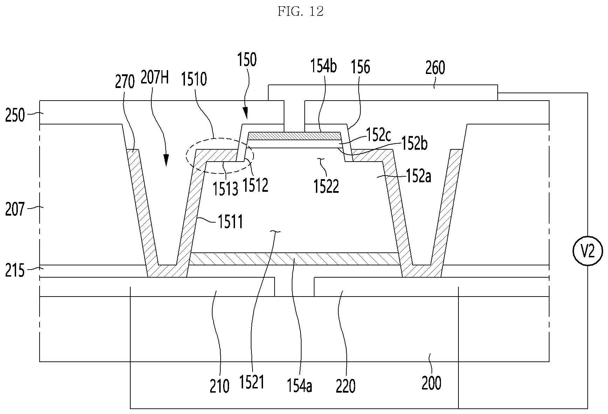

FIG. 12 illustrates a light-emitting process of a display device according to the first embodiment.

As illustrated in FIG. 12, after the semiconductor light-emitting device 150 is fixed on the substrate 200 by a self-assembly process (FIG. 11), a series of post-processes, such as a process for forming each of the second insulating layer 250 and the electrode wiring 260, and various circuit configurations comprising a driving circuit, can be mounted to manufacture the display device 301.

The semiconductor light-emitting device 150 can emit light to display an image in the display device 301. To this end, the first assembling wiring 210 and/or the second assembling wiring 220 can be used as the first electrode wiring, and the electrode wiring 260 can be used as the second electrode wiring. For example, a second voltage V2 may be applied to the semiconductor light-emitting device 150 so that the semiconductor light-emitting device 150 may emit light. The second voltage V2 causes current to flow through the electrode wiring 260, the semiconductor light-emitting device 150, and the first assembling wiring 210 and/or the second assembling wiring 220, and electrons may be generated in the first conductivity type semiconductor layer 152a of the semiconductor light-emitting device 150 and holes may be generated in the second conductivity type semiconductor layer 152c by the current. These electrons and holes may be injected into the active layer 152b of the semiconductor light-emitting device 150 and recombined, thereby generating a specific color light. The wavelength of the specific color light may vary depending on the semiconductor material, mixture, or composition ratio of the mixture of the active layer 152b of the semiconductor light-emitting device 150.

For example, the electrode wiring 260 may be an anode electrode to which a positive potential (+) voltage is applied, and the second assembling wiring 220 may be a cathode electrode to which a negative potential (-) voltage is applied.

For example, the electrode wiring 260 may be a common electrode wiring that is commonly connected to a plurality of sub-pixels of each of a plurality of pixels. The electrode wiring 260 may be a transparent electrode with excellent transparency so as not to interfere with the progress of the light generated from the semiconductor light-emitting device 150. For example, the transparent electrode may comprise ITO, IZO, etc., but is not limited thereto.

If the electrode wiring 260 is grounded as a common electrode, by varying the voltage applied to the second assembling wiring 220, the intensity of the current flowing through the semiconductor light-emitting device 150 may vary, and the luminance of the light generated from the semiconductor light-emitting device 150 may be changed due to the varied current. In this way, images with different gray-scales can be displayed in each of the plurality of sub-pixels of each of the plurality of pixels according to the changed luminance of the light.

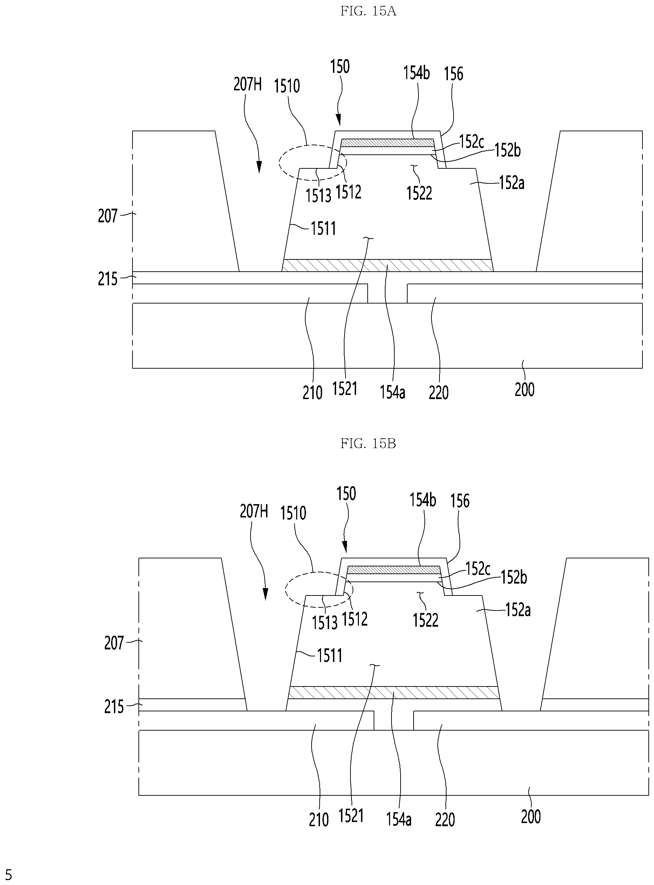

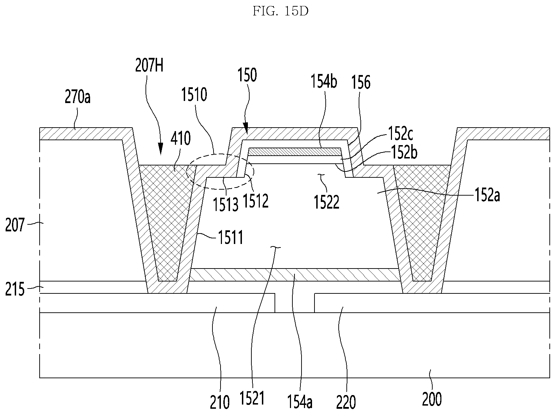

Referring to FIGS. 15A to 15F, a method for manufacturing a display device according to the first embodiment will be described.

FIGS. 15A to 15F are drawings explaining a method for manufacturing a display device according to the first embodiment.

As illustrated in FIG. 15A, a semiconductor light-emitting device 150 can be assembled into an assembly hole 207H on a substrate 200 using a self-assembly process (FIG. 6). A step difference part 1510 can be formed on the side portion of the semiconductor light-emitting device 150.

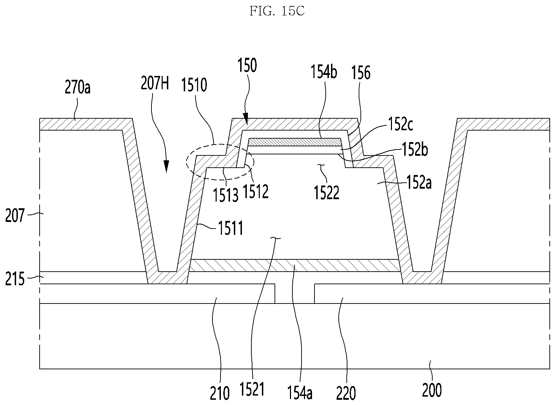

Although not illustrated, an ashing process can be performed to reduce the height of the partition wall 207. As will be described later, since the gap between the inner side of the partition wall 207 and the outer side of the semiconductor light-emitting device 150 in the assembly hole 207H is very narrow, it is very difficult to form a metal film (270a in FIG. 15C) for forming a connection electrode 270. Even if the metal film 270a is formed between the inner side of the partition wall 207 and the outer side of the semiconductor light-emitting device 150, an electrical-disconnected circuit may occur. In particular, the higher the height of the partition wall 207, the higher the possibility of such an electrical-disconnected circuit. Therefore, by performing an ashing process to remove the upper side of the partition wall 207, the height of the partition wall 207 can be lowered. Since the height of the partition wall 207 is low, not only can the metal film 270a be easily formed between the inner side of the partition wall 207 and the outer side of the semiconductor light-emitting device 150, but also the possibility of an electrical-disconnected circuit can be reduced.

As shown in FIG. 15B, the insulating layer 215 in the assembly hole 207H can be removed using an etching process. The etching process can be either a dry etching process or a wet etching process.

Since the insulating layer 215 is removed after the semiconductor light-emitting device 150 is assembled in the assembly hole 207H, the insulating layer 215 exposed between the outer side of the semiconductor light-emitting device 150 and the inner side of the partition wall 207 in the assembly hole 207H can be removed. A part of the insulating layer 215 under the partition wall 207 that contacts the assembly hole 207H or a part of the insulating layer 215 under the semiconductor light-emitting device 150 can be further removed by the over-etching process.

As shown in FIG. 15C, a metal film 270a may be formed on the substrate 200. The metal film 270a may be formed not only on the assembly hole but also on the partition wall 207 and the semiconductor light-emitting device 150.

The metal film 270a may comprise at least one or more film. Some of the metal film 270a may be formed as a connection electrode 270 later.

As shown in FIG. 15C, an organic film 410 may be formed on the substrate 200, and an exposure process and an ashing process may be performed to form the organic film 410 in the assembly hole 207H. The organic film may be made of a photosensitive material. For example, the organic film 410 may be formed along the perimeter of the side portion of the semiconductor light-emitting device 150 within the assembly hole 207H.

For example, the upper surface of the organic film 410 may be positioned lower than the upper surface of the semiconductor light-emitting device 150 or the upper surface of the metal film 270a on the semiconductor light-emitting device 150.

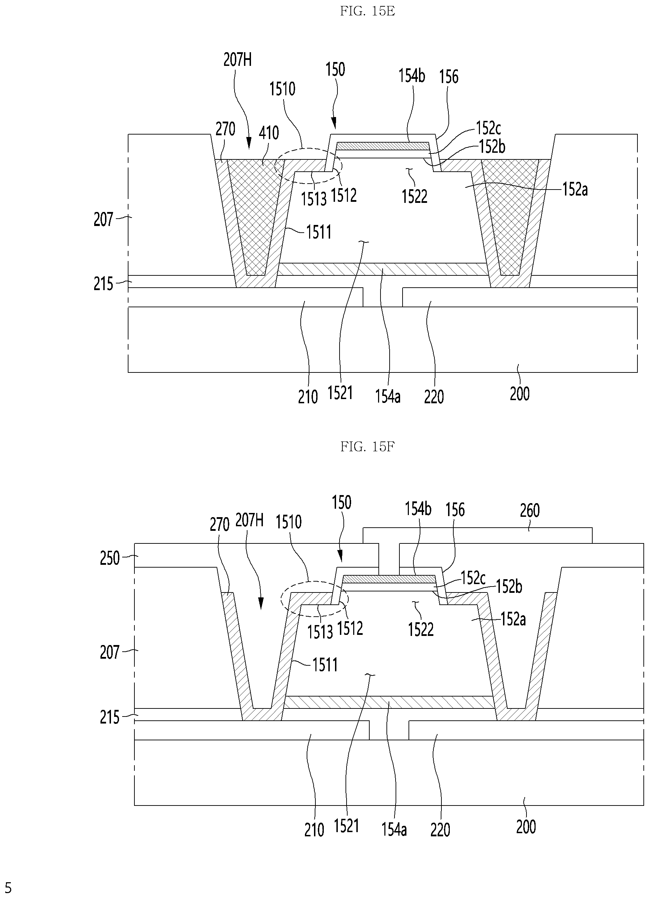

As illustrated in FIG. 15E, an etching process may be performed using the organic film 410 as a mask to remove the metal film 270a. The metal film 270a positioned higher than the upper surface of the metal film 270a may be removed by the etching process. Accordingly, a metal film 270a having a height equal to the upper surface of the organic film 410 may remain as a connection electrode 270 within the assembly hole 207H.

Although not illustrated, the organic film 410 may not be removed on the metal film 270a on the bottom area 1513 of the step difference part 1510 of the semiconductor light-emitting device 150. Accordingly, when the metal film 270a is removed, the metal film 270a on the bottom area 1513 of the step difference part 1510 may not be removed by the organic film 410. The organic film 410 on the metal film 270a may be removed by a post-process.

As shown in FIG. 15F, the organic film 410 may be removed, thereby forming the connection electrode 270.

The semiconductor light-emitting device 150 and the first assembling wiring 210 and/or the second assembling wiring 220 may be electrically connected by the connection electrode 270. The connection electrode 270 may be connected to not only the first-first side region of the semiconductor light-emitting device 150 but also to the bottom area 1513. The connection electrode 270 may be formed on the inner side of the partition wall 207 that contacts the assembly hole 207H. The end of the connection electrode 270 formed on the inner side of the partition wall 207 may be positioned on the same horizontal line as the upper surface of the connection electrode 270 on the bottom area 1513 of the step difference part 1510 of the semiconductor light-emitting device 150, but is not limited thereto.

### [Second Embodiment]

FIG. 16 is a plan view illustrating a display device according to a second embodiment.

The embodiment is the same as the first embodiment except that the connection electrode 270 is disposed on the passivation layer 156 of the semiconductor light-emitting device 150. In the second embodiment, components having the same shape, structure, and/or function as those in the first embodiment are given the same drawing reference numerals and detailed descriptions are omitted.

Referring to FIG. 16, the display device 302 according to the second embodiment may comprise a substrate 200, a first assembling wiring 210, a second assembling wiring 220, a partition wall 207, a semiconductor light-emitting device 150, and a connection electrode 270. The display device 302 according to the second embodiment may comprise more components than these.

A step difference part 1510 may be disposed on the side portion of the semiconductor light-emitting device 150. Specifically, the step difference part 1510 may be disposed along the perimeter of the side portion of the first conductivity type semiconductor layer 152a of the semiconductor light-emitting device 150, but is not limited thereto.

The first conductivity type semiconductor layer 152a may comprise a first-first conductivity type semiconductor layer 1521 and a first-second conductivity type semiconductor layer 1522.

The side portion of the conductivity type semiconductor layer, that is, the first-first side region 1511, may extend from the side portion of the first-second conductivity type semiconductor layer, that is, the first-second side region 1512 along the outer direction of the semiconductor light-emitting device 150.

The step difference part 1510 may comprise the first-first side region 1511, the bottom region 1513, and the first-second side region 1512. The bottom region 1513 may be disposed on the upper side of the first-first conductivity type semiconductor layer extending in the outer direction from the first-second side region 1512. That is, the bottom region 1513 may be disposed on the upper side of the first-first conductivity type semiconductor layer between the first-first side region 1511 and the first-second side region 1512.

The passivation layer 156 may be disposed on the upper side of the second conductivity type semiconductor layer 152c as well as on the side portion of the second conductivity type semiconductor layer 152c and the side portion of the active layer 152b. In addition, the passivation layer 156 may be disposed on the first-second side region 1512 of the step difference part 1510.

For example, the connection electrode 270 may be disposed on the step difference part 1510. That is, the connection electrode 270 may be in contact with the side portion of the first electrode 154a. For example, the connection electrode 270 may be in contact with the first-first side region 1511 and the bottom region 1513 of the step difference part 1510.

For example, the connection electrode 270 can be disposed on the passivation layer 156. Specifically, the connection electrode 270 can be disposed on the passivation layer 156 disposed on the first-second side region 1512 of the step difference part 1510. An electrical short between the connection electrode 270 and the active layer 152b or the second conductivity type semiconductor layer 152c can be prevented by the passivation layer 156.

Therefore, the connection electrode 270 may be disposed on the side portion of the first electrode 154a as well as the step difference part 1510 and the passivation layer 156, so that a wider area of the semiconductor light-emitting device 150 can be covered by the connection electrode 270, thereby enhancing the fixation of the semiconductor light-emitting device 150.

Meanwhile, the connection electrode 270 can be electrically connected to the first assembling wiring 210 and/or the second assembling wiring 220 through the first insulating layer 215.

In addition, the connection electrode 270 can be disposed on the inner side surface of the partition wall 207 that contacts the assembly hole 207H. The end of the connection electrode 270 disposed on the inner surface of the partition wall 207 may be positioned on the same horizontal line as the end of the connection electrode 270 disposed on the passivation layer 156 of the semiconductor light-emitting device 150, but is not limited thereto.

### [Third Embodiment]

FIG. 17 is a plan view illustrating a display device according to a third embodiment.

The embodiment is the same as the first embodiment except that the first electrode 154a is disposed on the step difference part 1510 and the connection electrode 270 is in contact with the first electrode 154a. The structure in which the first electrode 154a is disposed on the step difference part 1510 and the connection electrode 270 is in contact with the first electrode 154a can be applied to the second embodiment in the same manner as the third embodiment. In the third embodiment, components having the same shape, structure, and/or function as those in the first embodiment are given the same drawing reference numerals and detailed descriptions are omitted.

Referring to FIG. 17, the display device 303 according to the third embodiment may comprise a substrate 200, a first assembling wiring 210, a second assembling wiring 220, a partition wall 207, a semiconductor light-emitting device 150, and a connection electrode 270. The display device 303 according to the third embodiment may comprise more components than these.

A step difference part 1510 may be disposed on the side portion of the semiconductor light-emitting device 150. Specifically, the step difference part 1510 may be disposed along the perimeter of the side portion of the first conductivity type semiconductor layer 152a of the semiconductor light-emitting device 150, but is not limited thereto.

The first conductivity type semiconductor layer 152a may comprise a first-first conductivity type semiconductor layer 1521 and a first-second conductivity type semiconductor layer 1522.

The side portion of the conductivity type semiconductor layer, that is, the first-first side region 1511, may extend outward from the side portion of the first-second conductivity type semiconductor layer, that is, the first-second side region 1512.

The step difference part 1510 may comprise a first-first side region 1511, a bottom region 1513, and a first-second side region 1512. The bottom region 1513 may be disposed on an upper side of the first-first conductivity type semiconductor layer extending outward from the first-second side region 1512. That is, the bottom region 1513 may be disposed on the upper side of the first-first conductivity type semiconductor layer between the first-first side region 1511 and the first-second side region 1512.

The semiconductor light-emitting device 150 may comprise a first electrode 154a under the first conductivity type semiconductor layer and a second electrode 154b on the second conductivity type semiconductor layer 152c.

The first electrode 154a may be disposed on the side portion of the semiconductor light-emitting device 150. For example, the first electrode 154a may be disposed on the step difference part 1510. In this case, the connection electrode 270 may be in contact with the first electrode 154a disposed on the step difference part 1510. That is, the connection electrode 270 can be electrically connected to the first electrode 154a disposed on the step difference part 1510. For example, the first electrode 154a can be disposed on the first-first side region 1511 and the bottom region 1513 of the step difference part 1510, and the connection electrode 270 can contact the first electrode 154a disposed on the first-first side region 1511 and the bottom region 1513.

The first electrode 154a can comprise at least one or more layer comprising an ohmic layer. When the first electrode 154a is an ohmic layer, the contact resistance between the connection electrode 270 and the first conductivity type semiconductor layer 152a can be reduced, so that the current can flow more smoothly in the semiconductor light-emitting device 150 to improve the electrical and optical characteristics. In addition, instead of directly contacting the connection electrode 270 and the first conductivity type semiconductor layer 152a, the connection electrode 270 may contact the first conductivity type semiconductor layer 152a through the first electrode 154a comprising the ohmic layer, and contact the entire area of the first electrode 154a disposed along the perimeter of the side portion of the semiconductor light-emitting device 150, so that the electrical contact area can be significantly expanded further to improve the electrical characteristics and optical characteristics.

An electrical short between the first electrode 154a and the connection electrode 270 disposed on the bottom area 1513 of the step difference part 1510 and the active layer 152b or the second conductivity type semiconductor layer 152c of the semiconductor light-emitting device 150 can be prevented by the passivation layer 156.

Meanwhile, the connection electrode 270 may be electrically connected to the first assembling wiring 210 and/or the second assembling wiring 220 through the first insulating layer 215.

In addition, the connection electrode 270 may be disposed on the inner side surface of the partition wall 207 that contacts the assembly hole 207H. The end of the connection electrode 270 disposed on the inner side surface of the partition wall 207 may be positioned on the same horizontal line as the upper surface of the connection electrode 270 disposed on the first electrode 154a corresponding to the bottom area 1513 of the semiconductor light-emitting device 150, but is not limited thereto.

### [Fourth embodiment]

FIG. 18 is a plan view illustrating a display device according to a fourth embodiment.

The embodiment is the same as the first embodiment except that the second step difference part 1530 is disposed on the side portion of the partition wall 207 and the connection electrode 270 is disposed on the second step difference part 1530. The structure in which the second step difference part 1530 is disposed on the side portion of the partition wall 207 and the connection electrode 270 is disposed on the second step difference part 1530 can be applied to each of the second and third embodiments in the same manner as the fourth embodiment. In the fourth embodiment, components having the same shape, structure, and/or function as those in the first embodiment are given the same drawing reference numerals and detailed descriptions are omitted.

Referring to FIG. 18, the display device 304 according to the fourth embodiment may comprise a substrate 200, a first assembling wiring 210, a second assembling wiring 220, a partition wall 207, a semiconductor light-emitting device 150, and a connection electrode 270. The display device 304 according to the fourth embodiment may comprise more components than this.

The partition wall 207 may have a second step difference part 1530 on the side portion. At this time, the side portion may be an inner side portion that contacts the assembly hole 207H.

A semiconductor light-emitting device 150 may be disposed in the assembly hole 207H. The center of the semiconductor light-emitting device 150 may be located at the center of the assembly hole 207H.

The partition wall 207 may comprise a first partition wall 2071 and a second partition wall 2072.

The first partition wall 2071 may be spaced apart from the semiconductor light-emitting device 150 by a first distance d1. That is, the first partition wall 2071 can be spaced apart from the outer side surface of the semiconductor light-emitting device 150 by a first distance d1. The first partition wall 2071 can be spaced apart from the side portion of the first conductivity type semiconductor layer 152a of the semiconductor light-emitting device 150 by a first distance d1.

The partition wall 2072 can be disposed on the first partition wall 2071. The first partition wall 2071 and the second partition wall 2072 can be formed integrally comprising the same material or can be formed as separate layers comprising different materials. The second partition wall 2072 can be spaced apart from the semiconductor light-emitting device 150 by a second distance d2. That is, the second partition wall 2072 can be spaced apart from the outer side surface of the semiconductor light-emitting device 150 by a second distance d2. The second partition wall 2072 may be spaced apart from the side portion of the second conductivity type semiconductor layer 152c of the semiconductor light-emitting device 150 by a second distance d2. The second distance d2 may be greater than the first distance d1.

The side portion of the first partition wall 2071 may extend from the side portion of the second partition wall 2072 toward the semiconductor light-emitting device 150 along the outer direction of the partition wall 207. The outer direction may be a horizontal direction.

The step difference part 1530 may comprise a second-first side region 1531, a second bottom region 1533, and a second-second side region 1532. The second-first side region 1531 may be disposed on the side portion of the first partition wall 2071, and the second-second side region 1532 may be disposed on the side portion of the second partition wall 2072. The second bottom region 1533 may be disposed on the upper side of the first partition wall 2071 extending from the side portion of the second partition wall 2072 toward the semiconductor light-emitting device 150 along the outer direction of the partition wall 207. That is, the second bottom region 1533 may be disposed on the upper side of the first partition wall 2071 between the first partition wall 2071 and the second partition wall 2072.

For example, the connection electrode 270 may be disposed on the second-first side region 1531 and the second bottom region 1533 of the second step difference part 1530. For example, the connection electrode 270 may be electrically connected to the first assembling wiring 210 and/or the second assembling wiring 220 along the periphery of the semiconductor light-emitting device 150 through the insulating layer 215 within the assembly hole 207H. For example, the connection electrode 270 may be disposed on the side portion of the semiconductor light-emitting device 150. When the first step difference part 1510 is disposed on the side portion of the semiconductor light-emitting device 150, the connection electrode 270 may be disposed on the first step difference part 1510. Since the arrangement of the first step difference part 1510 and the connection electrode 270 on the first step difference part 1510 has been described in the first to third embodiments, a detailed description thereof will be omitted.

Although the drawing shows that the first step difference part 1510 of the semiconductor light-emitting device 150 and the second step difference part 1530 of the partition wall 207 are positioned on the same horizontal line, they may not be positioned on the same horizontal line. For example, the second step difference part 1530 of the partition wall 207 may be positioned lower than the first step difference part 1510 of the semiconductor light-emitting device 150, but is not limited thereto.

According to the embodiment, the first step difference part 1510 may be positioned on the side portion of the semiconductor light-emitting device 150, the second step difference part 1530 may be positioned on the side portion of the partition wall 207, and the connection electrode 270 may be positioned on each of the first step difference part 1510 and the second step difference part 1530, so that product reliability can be improved by strengthening the fixation of the semiconductor light-emitting display 150.

### [Fifth Embodiment]

FIG. 19 is a plan view illustrating a display device according to a fifth embodiment.

The embodiment is the same as the first embodiment except that the first assembling wiring 210 and the second assembling wiring 220 are disposed in different layers. The structure in which the first assembling wiring 210 and the second assembling wiring 220 are disposed in different layers can be applied to each of the second to fourth embodiments in the same manner as the fifth embodiment. In the fifth embodiment, components having the same shape, structure, and/or function as those in the first embodiment are given the same drawing reference numerals and detailed descriptions are omitted.

Referring to FIG. 19, the display device 305 according to the second embodiment may comprise a substrate 200, a first assembling wiring 210, a second assembling wiring 220, a partition wall 207, a semiconductor light-emitting device 150, and a connection electrode 270. The display device 305 according to the fifth embodiment may comprise a first insulating layer 215, a second insulating layer 250, and electrode wiring 260. The display device 305 according to the fifth embodiment may comprise more components than these.

The first assembling wiring 210 and the second assembling wiring 220 may be disposed in different layers. For example, the first assembling wiring 210 may be disposed under the first insulating layer 215, and the second assembling wiring 220 may be disposed on the first insulating layer 215.

For example, the upper surface of the second assembling wiring 220 and the upper surface of the first insulating layer 215 may be positioned on the same horizontal line. For this purpose, for example, the thickness of the first assembling wiring 210 and the thickness of the second assembling wiring 220 may be the same, and the first insulating layer 215 may have a thickness smaller than the thickness of the first assembling wiring 210 or the second assembling wiring 220.

In this way, by positioning the upper surface of the second assembling wiring 220 and the upper surface of the first insulating layer 215 on the same horizontal line, the semiconductor light-emitting device 150 may be assembled in the normal position without being tilted within the assembly hole 207H.

The connection electrode 270 may be in contact with a part of the upper surface of the second assembling wiring 220. When the semiconductor light-emitting device 150 is assembled in the assembly hole 207H, the lower surface of the first electrode 154a on the lower side of the semiconductor light-emitting device 150 may be in contact with the upper surface of the second assembling wiring 220. The second assembling wiring 220 may be disposed to overlap the assembly hole 207H and the partition wall 207, so that a part of the second assembling wiring 220 may be exposed around the semiconductor light-emitting device 150 within the assembly hole 207H. The connection electrode 270 may be electrically connected to a part of the second assembling wiring 220 exposed in this way. In this case, the connection electrode 270 may not only contact a part of the second assembling wiring 220, but also contact the side portion of the first electrode 154a of the semiconductor light-emitting device 150.

Meanwhile, the first step difference part 1510 may be disposed on the side portion of the semiconductor light-emitting device 150, and the connection electrode 270 may be disposed on the first step difference part 1510.

As described above, various arrangement structures of the connection electrode 270 are possible. For example, the connection electrode 270 may be disposed on the passivation layer 156 of the semiconductor light-emitting device 150 (FIG. 16). For example, the first electrode 154a comprising the ohmic layer may be disposed on the first step difference part 1510 of the semiconductor light-emitting device 150, and the connection electrode 270 may be disposed on the first electrode 154a corresponding to the first step difference part 1510 (FIG. 17). For example, the second step difference part 1530 may be disposed on the side portion of the partition wall 207, and the connection electrode 270 may be disposed on the second step difference part 1530 (FIG. 18). A more detailed arrangement structure of the connection electrode 270 may be easily understood from the second to fourth embodiments described above.

Meanwhile, although the drawing shows that the first assembly wiring 210 is not electrically connected to the connection electrode 270, it may be connected to the first assembling wiring 210 through the first insulating layer 215.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

The embodiment can be adopted in the display field for displaying images or information. The embodiment can be adopted in the display field for displaying images or information using a semiconductor light-emitting device. The semiconductor light-emitting device can be a micro-level semiconductor light-emitting device or a nano-level semiconductor light-emitting device.

For example, the embodiment can be adopted in TVs, signage, smart phones, mobile phones, mobile terminals, HUDs for automobiles, backlight units for laptops, and display devices for VR or AR.

## Claims

1. A display device, comprising:
a substrate;
a first assembling wiring on the substrate;
a second assembling wiring on the substrate;
a partition wall disposed on the first and second assembling wirings and having a hole;
a semiconductor light-emitting device disposed in the hole and having a first step difference part on a side portion thereof; and
a connection electrode disposed on at least the first step difference part.

2. The display device according to claim 1, wherein the semiconductor light-emitting device comprises:
a first conductivity type semiconductor layer;
an active layer on the first conductivity type semiconductor layer; and
a second conductivity type semiconductor layer on the active layer; and
a passivation layer surrounding at least the active layer and the second conductivity type semiconductor layer,
wherein the first step difference part is disposed on a side portion of the first conductivity type semiconductor layer.

3. The display device according to claim 2, wherein the first conductivity type semiconductor layer comprises:
a first-first conductivity type semiconductor layer having a first width; and
a first-second conductivity type semiconductor layer disposed on the first-first conductivity type semiconductor layer and having a second width smaller than the first width.

4. The display device according to claim 3, wherein the first step difference part comprises:
a first-first side region on a side portion of the first-first conductivity type semiconductor layer;
a first-second side region on a side portion of the first-second conductivity type semiconductor layer; and
a first bottom region on an upper side of the first-first conductivity type semiconductor layer between the first-first side region and the first-second side region.

5. The display device according to claim 4, wherein the connection electrode is in contact with the first-first side region and the first bottom region.

6. The display device according to claim 4, wherein the passivation layer is disposed between the first-first side region and the connection electrode.

7. The display device according to claim 4, wherein the semiconductor light-emitting device comprises:
a first electrode below the first conductivity type semiconductor layer; and
a second electrode on the second conductivity type semiconductor layer.

8. The display device according to claim 7, wherein the connection electrode is in contact with a side portion of the first electrode.

9. The display device according to claim 2, wherein the connection electrode is disposed on the passivation layer.

10. The display device according to claim 1, wherein the first electrode is disposed on the first step difference part, and the connection electrode is in contact with the first electrode.

11. The display device according to claim 1, wherein the partition wall has a second step difference part on a side portion thereof.

12. The display device according to claim 11, wherein the partition wall comprises:
a first partition wall spaced apart from the semiconductor light-emitting device by a first distance; and
a second partition wall spaced apart from the semiconductor light-emitting device by a second distance and disposed on the first partition wall, the second distance being greater than the first distance.

13. The display device according to claim 12, wherein the second step difference part comprises:
a second-first side region on a side portion of the first partition wall;
a second-second side region on a side portion of the second partition wall; and
a second bottom region on an upper side of the second partition wall between the first partition wall and the second partition wall.

14. The display device according to claim 13, wherein the connection electrode is disposed on the second-first side region and the second bottom region.

15. The display device according to claim 1, wherein the first assembling wiring and the second assembling wiring are disposed on the same layer, and the connection electrode is electrically connected to the first assembling wiring and the second assembling wiring.

16. The display device according to claim 1, wherein the first assembling wiring and the second assembling wiring are disposed on different layers, and the connection electrode is electrically connected to at least one of the first assembling wiring or the second assembling wiring.

17. The display device according to claim 1, further comprising:
an electrode wiring disposed on the semiconductor light-emitting device,
wherein the electrode wiring is electrically connected to an upper side of the semiconductor light-emitting device, and
wherein at least one of the first assembly wiring or the second assembly wiring is electrically connected to the side portion of the semiconductor light emitting element through the connecting electrode.
